# FASCICULE DE BREVET EUROPEEN

(11) **EP 4 098 606 B1**
(45) Date de publication et mention de la délivrance du brevet: **01.05.2024**
(21) Numéro de dépôt: 22175727.1
(22) Date de dépôt: 27.05.2022
(51) Int. Cl.: B81B 3/00

(54) **MICROSYSTÈME ÉLECTROMÉCANIQUE**
ELEKTROMECHANISCHES MIKROSYSTEM
ELECTROMECHANICAL MICROSYSTEM

(30) Priorité: 31.05.2021 FR 2105643
(43) Date de publication de la demande: 07.12.2022
(73) Titulaire: Commissariat à l'énergie atomique et aux énergies alternatives, 75015 Paris (FR)
(72) Inventeur: MOLLARD, Laurent, 38054 GRENOBLE Cedex 09 (FR); NICOLAS, Stéphane, 38054 GRENOBLE Cedex 09 (FR); SAINT-PATRICE, Damien, 38054 GRENOBLE Cedex 09 (FR)
(74) Mandataire: Hautier IP - MC/EP

(56) Documents cités:
- DE-A1-102017 200 057

## Description

### DOMAINE TECHNIQUE

La présente invention concerne le domaine des microsystèmes électromécaniques. Elle trouve par exemple pour application particulièrement avantageuse l'actionnement ou le déplacement d'objets, y compris sur des distances relativement grandes. Elle trouve également pour application des dispositifs de préhension qui permettent la capture ou l'expulsion d'objets de petites tailles. L'invention trouve également pour application le domaine de la détection par contact. Elle pourra ainsi être mise en oeuvre pour réaliser des capteurs.

### ÉTAT DE LA TECHNIQUE

Dans des applications variées, on peut avoir besoin de déplacer, capturer ou expulser des objets microscopiques, voire nanoscopiques, et/ou avoir besoin de capter des mouvements de tels objets. Il existe des microsystèmes qui permettent cela.

Lorsque ces microsystèmes sont des actionneurs ou des dispositifs de préhension, leurs performances sont évaluées notamment sur les paramètres suivants : l'amplitude du déplacement, la force déployée, la précision du déplacement généré ou encore la précision de la capture ou de l'expulsion d'un objet. Lorsque ces microsystèmes sont des capteurs, leurs performances sont évaluées notamment sur les paramètres suivants: la capacité à capter un mouvement sur une amplitude importante et la précision de la mesure.

Par ailleurs, que les microsystèmes soient des actionneurs, des dispositifs de préhension ou des capteurs, on recherche à ce qu'ils offrent de bonnes performances en termes d'encombrement, de consommation énergétique et de capacité à travailler en fréquence.

Toutes les solutions connues présentent des performances faibles pour l'un au moins de ces paramètres. Généralement, les microsystèmes existants présentent des performances trop peu satisfaisantes pour une combinaison de ces paramètres. Un exemple de microsystème électromécanique connu est divulgué par le document DE 10 2017 200057 A1.

Un objet de la présente invention est de proposer un microsystème électromécanique qui présente des performances améliorées par rapport aux solutions existantes, au moins pour l'un des paramètres mentionnés ci-dessus, ou qui présente un meilleur compromis concernant au moins deux des paramètres susmentionnés.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation, on prévoit un microsystème électromécanique comprenant:
- au moins un transducteur électromécanique comprenant une partie mobile entre une position d'équilibre, hors sollicitation, et une position hors équilibre, sous sollicitation,
- au moins une membrane déformable,
- une cavité déformable, délimitée par des parois, au moins une partie de la membrane déformable formant au moins une partie d'une première paroi prises parmi lesdites parois de la cavité, la cavité étant configurée pour contenir hermétiquement un milieu déformable propre à conserver un volume sensiblement constant sous l'action d'un changement de pression externe exercée sur le milieu déformable à travers l'une des parois de la cavité.

La partie mobile du transducteur électromécanique est configurée de sorte que son mouvement soit fonction dudit changement de pression externe, ou inversement que son mouvement induise un changement de pression externe. Ladite au moins une partie de la membrane déformable présente au moins une zone libre de se déformer, de préférence de façon élastique, en fonction dudit changement de pression externe.

La zone libre présente un pourtour externe et une portion périphérique qui s'étend depuis le pourtour externe et jusqu'à une portion centrale de la zone libre.

Ainsi, le microsystème électromécanique proposé permet d'obtenir une inclinaison du pion selon un angle présentant une amplitude élevée relativement à la déformation de la membrane. Il est alors possible, même avec un microsystème électromécanique de petites dimensions d'obtenir de grands débattements. En particulier, la deuxième extrémité du pion, c'est-à-dire l'extrémité du pion opposée à son extrémité en appui sur la membrane, se déplace selon une grande course.

Typiquement, le déplacement de la deuxième extrémité de pion peut s'effectuer sur une longueur de course pouvant s'exprimer sous forme angulaire. Typiquement, la deuxième extrémité du pion se déplace d'un angle d'au moins 45° et de préférence comprise entre 0° et 90°.

Le microsystème électromécanique proposé présente donc une solution particulièrement efficace pour réaliser :
- un actionneur à grand débattement. Un tel actionneur autorise le déplacement d'un objet ou d'un organe externe déplacé par le ou les pions, typiquement avec une amplitude de l'ordre de 100 µm.
- un dispositif de préhension. En prévoyant plusieurs pions sur la zone libre de la membrane, en particulier sur sa portion périphérique, on parvient à ce que les extrémités des différents pions se rapprochent pour permettre de saisir, capturer ou retenir un objet entre les pions. Inversement, on peut commander l'éloignement des pions pour permettre de libérer ou expulser un objet. De même en prévoyant au moins un pion dont une extrémité libre est conformée pour coopérer avec un objet pour le saisir, le déplacement du pion permet de capturer ou de relâcher un objet. On peut également prévoir que le matériau du pion permette la capture d'un objet, par des forces d'adhésion ou des forces magnétiques.
- un capteur, autorisant typiquement à capter un déplacement imposé à au moins un pion. Ce déplacement peut être un déplacement selon une trajectoire courbe.

Le microsystème électromécanique tel qu'introduit ci-dessus est ainsi apte à déplacer le pion ou à capter un mouvement imposé à ce dernier, et ce en présentant, de façon aisément modulable en fonction des applications visées, une capacité suffisante en termes d'amplitude de déplacement et/ou une capacité suffisante en termes de force déployée et/ou une capacité de captation de mouvement, voire de capture, d'un objet et/ou une capacité suffisante à travailler en fréquence et/ou une taille compatible avec les applications visées, et/ou une consommation en énergie réduite.

Un autre aspect de l'invention concerne un système ou un microsystème opto-électro-mécanique comprenant au moins un microsystème électromécanique tel qu'introduit ci-dessus et au moins un microsystème optique.

De préférence, le microsystème optique comprend au moins un miroir, de préférence à base de silicium. Le système opto-électro-mécanique est configuré de sorte à ce que le mouvement de la partie mobile du transducteur électromécanique provoque un déplacement, de préférence une inclinaison, de l'au moins un miroir.

Un autre aspect de l'invention concerne un procédé de fabrication d'un microsystème électromécanique tel qu'introduit ci-dessus, comprenant, voire étant limité à, des étapes de dépôt et de gravure ordinaires en microélectronique. Le microsystème électromécanique peut en effet être fabriqué par des moyens ordinaires de la microélectronique, ce qui confère à son fabricant tous les avantages découlant de l'utilisation de ces moyens, dont une grande latitude en termes de dimensionnement, d'énergie d'adhésion entre les différents dépôts, d'épaisseur des différents dépôts, d'étendue de gravure, etc.

Selon un exemple le procédé de fabrication du microsystème électromécanique comprend les étapes suivantes :
- une étape de formation, sur un substrat, d'une portion au moins du transducteur électromécanique, puis
- une étape de dépôt de la membrane déformable, puis
- une étape de formation d'une cavité ouverte sur la membrane déformable, puis
- une étape de remplissage avec le milieu déformable et de fermeture de la cavité, et
- une étape de gravure du substrat pour former une face avant (FAV) du microsystème électromécanique.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 est un schéma de principe d'une vue en coupe d'un microsystème électromécanique selon un premier mode de réalisation de l'invention.
La figure 2 est un schéma de principe en vue du dessus du microsystème électromécanique illustré en figure 1. Sur les figures 1 et 2, le microsystème électromécanique est illustré dans une configuration dans laquelle la membrane n'est pas déformée.
La figure 3A représente le microsystème illustré en figures 1 et 2, dans une première configuration de déformation de la membrane.
La figure 3B représente le microsystème illustré en figures 1 et 2, dans une deuxième configuration de déformation de la membrane.
La figure 4 est un schéma de principe d'une vue en coupe d'un microsystème électromécanique selon un deuxième mode de réalisation de l'invention. Dans ce deuxième mode de réalisation, la zone libre de la membrane coopère avec plusieurs pions.
La figure 5 est un schéma de principe en vue du dessus du microsystème électromécanique illustré en figure 4. Sur les figures 4 et 5, le microsystème électromécanique est illustré dans une configuration dans laquelle la membrane n'est pas déformée.
Les figures 6A à 6E représentent le microsystème illustré en figures 4 et 5, dans des configurations de déformation de la membrane.

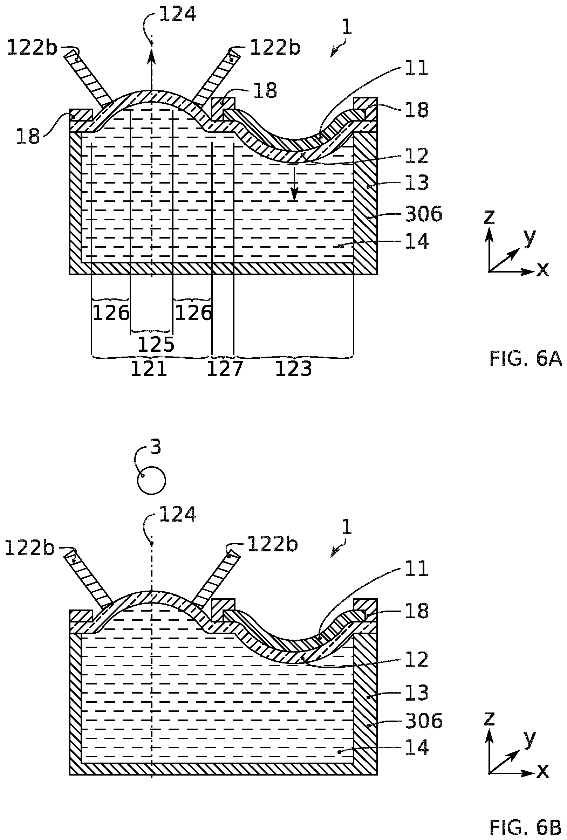

Les figures 6A et 6B illustrent une configuration dans laquelle les extrémités libres des pions sont éloignées les unes des autres, par exemple pour capturer un objet.

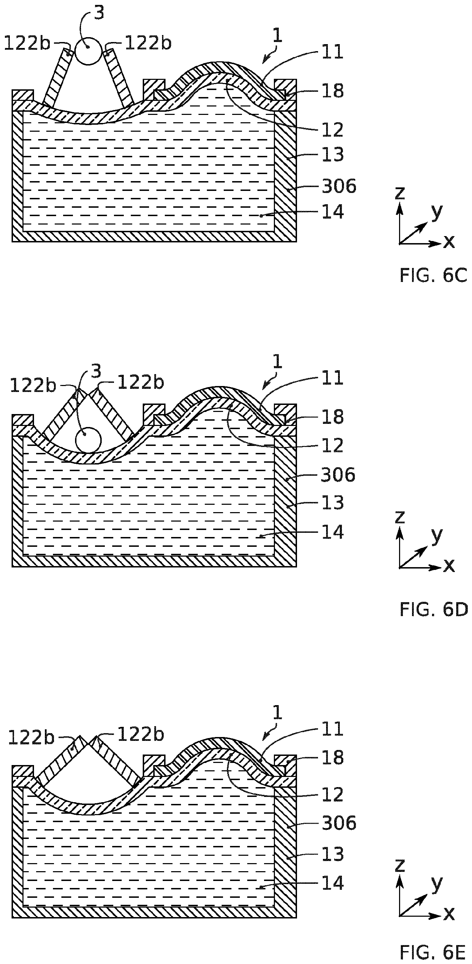

Les figures 6C à 6E illustrent une configuration dans laquelle les extrémités libres des pions sont rapprochées les unes des autres, par exemple pour permettre la saisie d'un objet ou empêcher la libération d'un objet capturé.

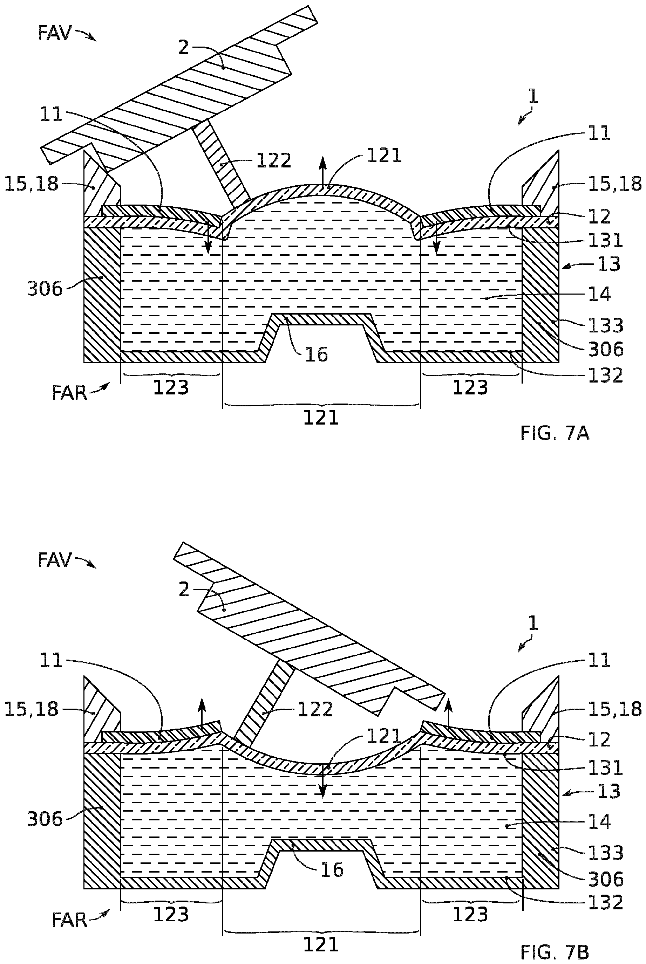

Les figures 7A et 7B sont des schémas de principe, vue en coupe, d'un microsystème électromécanique selon un autre mode de réalisation de l'invention dans lequel l'actionneur électromécanique entoure la zone libre de la membrane. Dans ce mode de réalisation, des butées latérales sont prévues. Sur la figure 7A, la membrane est représentée déformée selon une première configuration. Sur la figure 7B, la membrane est représentée déformée selon une deuxième configuration.

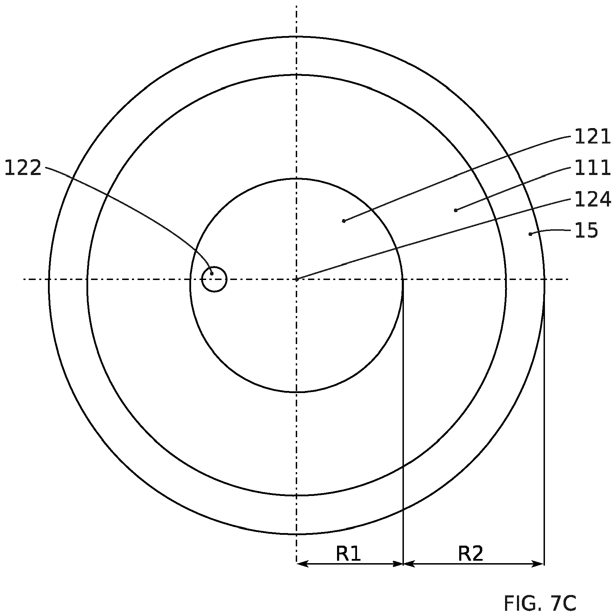

La figure 7C est un schéma de principe en vue du dessus du microsystème électromécanique illustré en figures 7A et 7B.

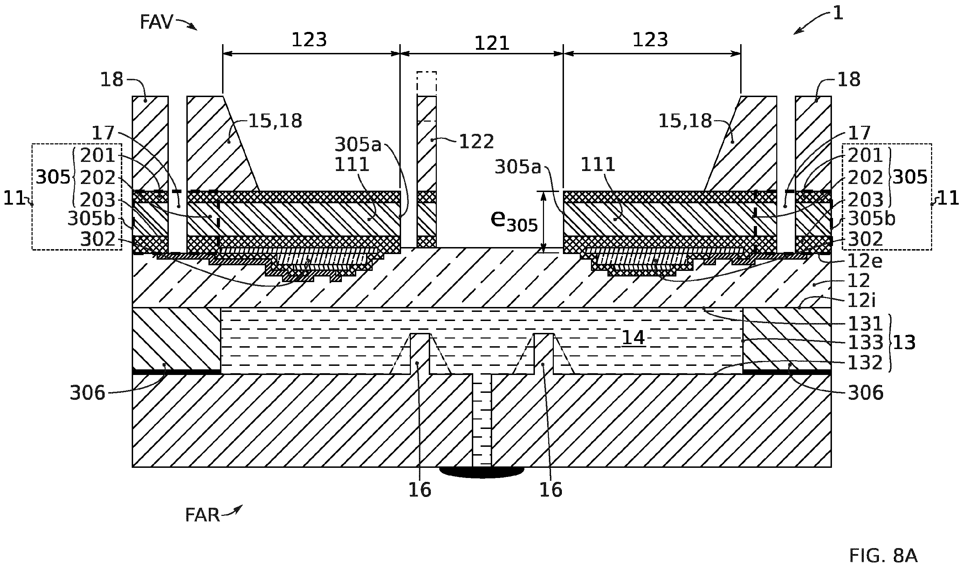

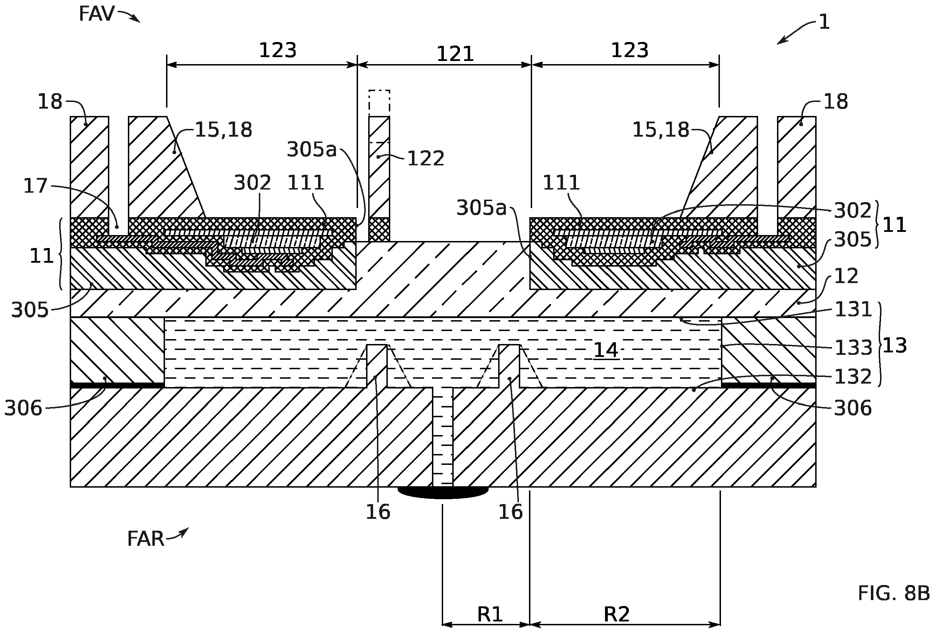

Les figures 8A et 8B sont des schémas, plus détaillés que ceux des figures 7A et 7B, et représentant des microsystèmes électromécaniques structurellement proches de ceux illustrés sur les figures 7A et 7B respectivement.

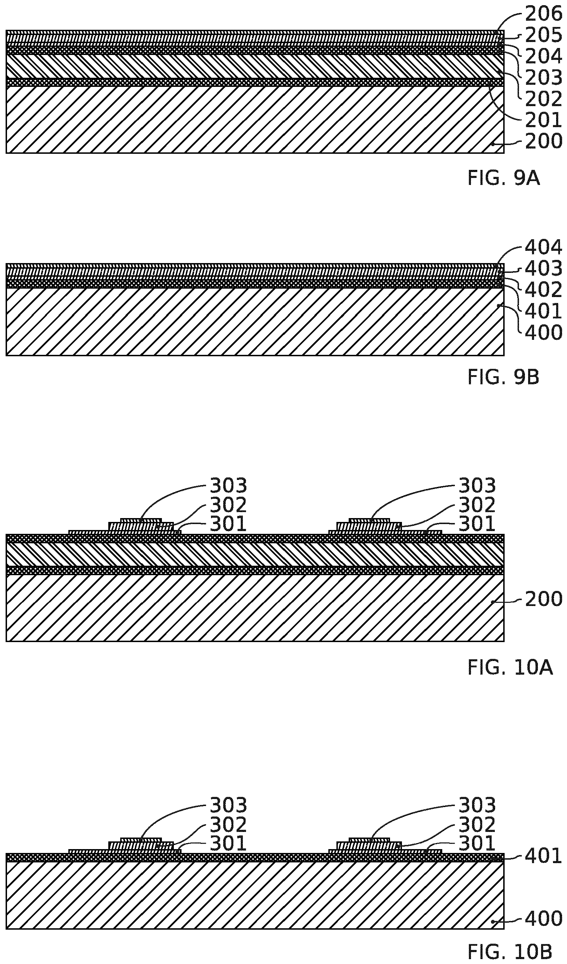

Les figures 9A à 15A représentent schématiquement des étapes d'un exemple de procédé de réalisation d'un microsystème électromécanique illustré en figure 8A.
Les figures 9B à 15B représentent schématiquement des étapes d'un exemple de procédé de réalisation d'un microsystème électromécanique illustré en figure 8B.

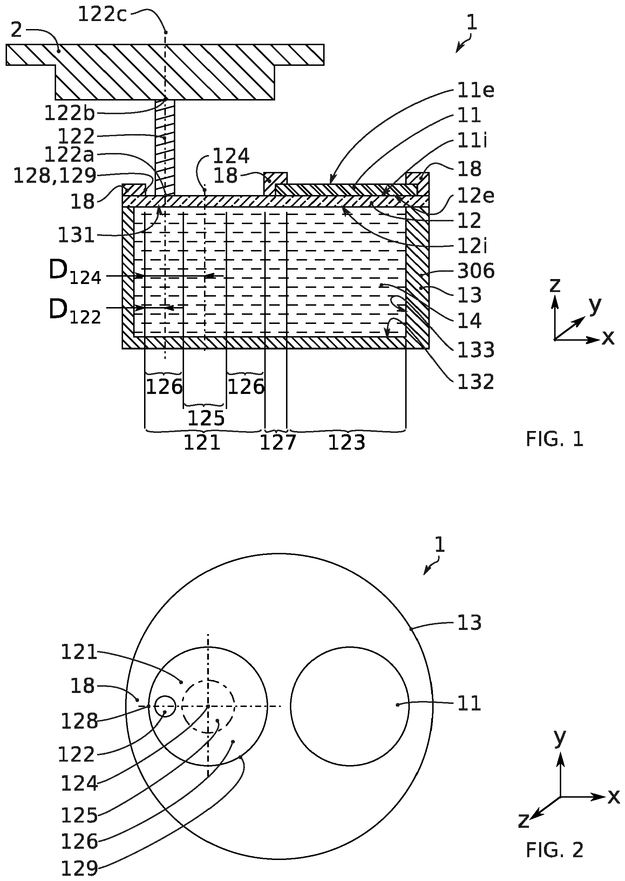

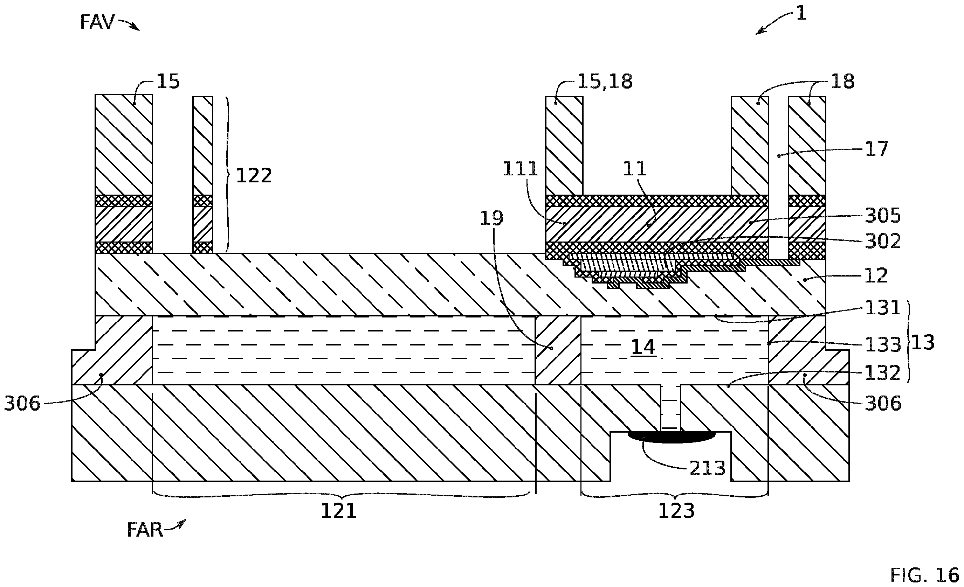

La figure 16 représente schématiquement un microsystème électromécanique proche de celui illustré en figure 1, mais avec un niveau de détail plus élevé.

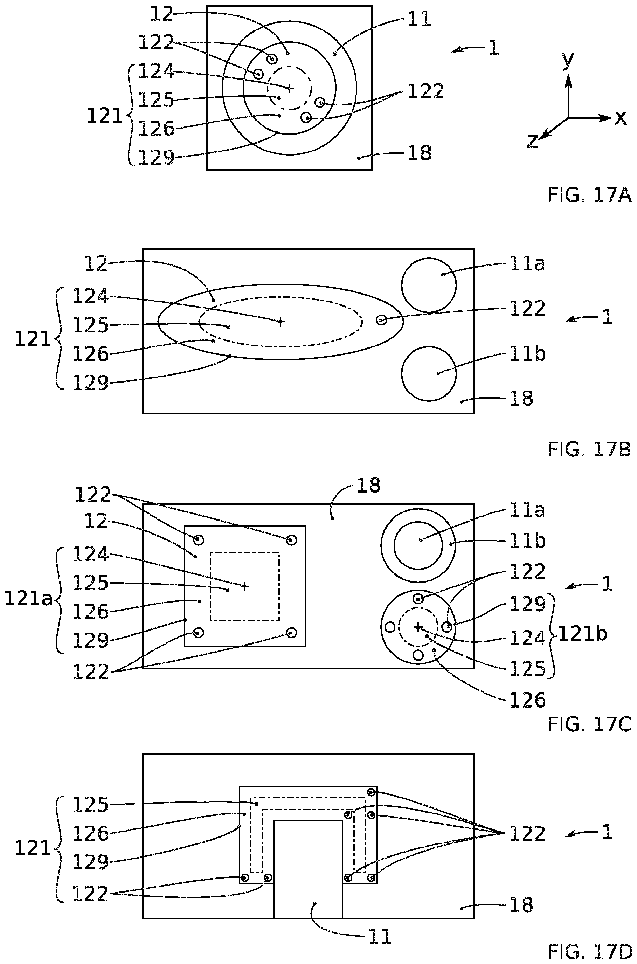

Les figures 17A à 17D représentent schématiquement des variantes du microsystème opto-électro-mécanique selon l'invention.

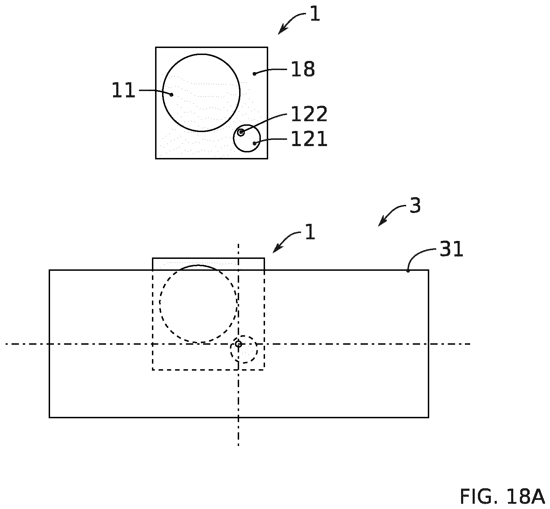

La figure 18A représente schématiquement un exemple de microsystème électromécanique comprenant un microsystème électromécanique.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs des différentes couches, parois et organes illustrés ne sont pas nécessairement représentatives de la réalité.

### DESCRIPTION DÉTAILLÉE

Selon un exemple, en l'absence de déformation, la zone libre de la membrane s'étend principalement dans un plan (xy), dit plan hors déformation ou plan au repos, et la perpendiculaire à la tangente en un point donné de la zone libre s'étend selon une direction T1 perpendiculaire au plan hors déformation.

Selon un exemple, lorsque la membrane se déforme, la perpendiculaire à la tangente en un point donné de la portion périphérique de la zone libre s'étend selon une direction Ti, inclinée par rapport à la direction T1, d'un angle αi (l'angle αi étant mesuré dans un plan perpendiculaire au plan hors déformation).

Selon un exemple, l'angle αi augmente au fur à mesure que l'on s'éloigne de la portion centrale et que l'on se rapproche du pourtour externe de la zone libre.

Selon un exemple, le microsystème électromécanique est configuré de sorte qu'une déformation de la zone libre de la membrane entraine une inclinaison du pion dans un plan perpendiculaire à un plan (xy) dans lequel s'étend principalement une face externe de la membrane lorsque la membrane n'est pas déformée.

Selon un exemple, l'inclinaison peut être mesurée par un angle α contenu dans un plan perpendiculaire au plan xy.

Selon un exemple, le pion s'étend principalement selon une direction longitudinale. Lorsque la membrane n'est pas déformée, la direction longitudinale du pion est sensiblement perpendiculaire à un plan (xy) dans lequel s'étend principalement une face externe de la membrane lorsque la membrane n'est pas déformée. Le pion peut présenter une forme cylindrique. Selon un mode de réalisation alternatif, le pion ne présente pas une forme cylindrique. Il peut présenter une forme courbe par exemple.

Selon un exemple, le pion présente une première extrémité par laquelle il prend appui sur la portion périphérique de la zone libre et une deuxième extrémité opposée à la première extrémité.

Selon un exemple, le microsystème électromécanique est configuré de sorte qu'une déformation de la zone libre de la membrane entraine une inclinaison de la première extrémité en direction de la portion centrale de la zone libre.

Selon un exemple, le pion s'étend entre la première extrémité et la deuxième extrémité principalement selon une direction longitudinale. Alternativement le pion présente une forme courbe ou s'étend selon plusieurs directions différentes.

Selon un exemple, la zone libre présente une portion centrale s'étendant depuis un centre de la zone libre et une portion périphérique disposée autour de la portion centrale.

Selon un exemple, la zone périphérique est continue. Elle présente un contour plein. Alternativement, elle présente un contour ouvert.

Selon un exemple, la portion centrale comprend un centre de la zone libre, le centre correspond par exemple au barycentre de la zone libre.

Selon un exemple, la zone libre forme un disque, une ellipse ou un polygone et ledit centre correspond au barycentre de la zone libre.

Selon un exemple, la zone libre est délimitée par un pourtour externe, le pion étant situé à une distance minimale D122 du pourtour externe, telle que D122 est inférieure à k fois une distance D124 :
- D122 étant mesurée entre le pion et le point du pourtour externe le plus proche du pion, et
- La distance D124 étant mesurée entre ce même point et le centre de la zone libre,
- k étant inférieur à 0,7, de préférence k étant inférieur à 0,5, de préférence k étant inférieur à 0,3.

Selon un mode de réalisation alternatif, la portion centrale ne forme pas un disque, une ellipse ou un polygone. La portion centrale peut entourer au moins partiellement le transducteur électromécanique. La portion centrale peut par exemple présenter une forme allongée. Cette forme allongée peut s'étendre selon plusieurs segments présentant des directions différentes.

Selon un exemple, le microsystème électromécanique comprend une pluralité de pions, prenant chacun appui sur la portion périphérique de la zone libre de sorte qu'une déformation de la zone libre de la membrane entraine une inclinaison des pions.

Selon un exemple, les pions présentent une extrémité libre, opposée à l'extrémité par laquelle ils prennent appui sur la portion périphérique de la zone libre, les pions étant conformés de sorte qu'une déformation de la zone libre de la membrane entraine sélectivement un rapprochement ou un éloignement, de leurs extrémités libres.

Selon un exemple, les pions sont conformés de sorte qu'une déformation de la zone libre de la membrane entraine sélectivement une mise en contact ou un éloignement des extrémités libres des pions.

Selon un exemple, les pions sont répartis sur la portion périphérique de sorte que le rapprochement de leurs extrémités libres permette de saisir entre les extrémités libres et/ou de retenir entre la membrane et les pions un objet externe au microsystème électromécanique. Le rapprochement de leurs extrémités libres permet de former une cage au-dessus de la zone libre de la membrane.

Ce mode de réalisation permet d'obtenir un dispositif de préhension particulièrement fiable et précis. En outre, le grand débattement angulaire des pions, permet de capturer et de relâcher des objets de tailles relativement grandes par rapport à la taille des pions et à la taille du microsystème électromécanique.

Dans ce mode de réalisation, l'objet n'est pas fixé au microsystème électromécanique. A fortiori, il n'est pas fixé aux pions.

Selon un autre mode de réalisation, l'objet est un organe externe.

Selon un exemple, le ou les pions sont configurés pour coopérer avec un objet formant un organe externe de sorte que le mouvement de la partie mobile du transducteur électromécanique soit fonction d'un déplacement du ou des pions entrainés par l'organe externe ou inversement que le mouvement de la partie mobile du transducteur électromécanique induise un déplacement, en particulier une inclinaison, de l'organe externe par l'intermédiaire du pion.

Ce mode de réalisation permet d'obtenir un actionneur fiable et précis ou un capteur. Le grand débattement angulaire des pions, permet un déplacement de l'organe externe sur une course relativement grande par rapport à la taille du ou des pions et à la taille du microsystème électromécanique.

Le ou les pions peuvent être configurés pour coopérer avec l'organe externe par l'intermédiaire d'un guide solidaire de l'organe externe, de sorte à permettre un positionnement automatique de l'organe externe sur le ou les pions.

Le ou les pions peuvent être configurés pour pouvoir être solidarisés avec l'organe externe par collage ou magnétisme, l'énergie d'adhérence du ou des pions sur la zone libre de la membrane déformable étant de préférence supérieure à celle du pion ou des pions sur l'organe externe. Une solidarisation, éventuellement amovible, du ou des pions et de l'organe externe est ainsi prévue qui est largement modulable en termes de force de retenue.

Selon un exemple, le microsystème électromécanique comprend en outre au moins une butée latérale, de préférence supportée par ladite première paroi de la cavité, configurée pour guider le mouvement de l'organe externe.

Selon un exemple, le pion s'étend depuis la zone libre de la membrane déformable au-delà de ladite au moins une butée latérale. Selon un exemple alternatif, le pion s'étend depuis la zone libre de la membrane déformable en-deçà de ladite butée latérale.

Selon un exemple, le pion est fixé sur ladite zone libre, de préférence au contact directe de ladite zone libre.

Selon un exemple, le microsystème électromécanique comprend une pluralité de transducteurs électromécaniques.

Selon un mode de réalisation, les transducteurs électromécaniques sont séparés les uns des autres. Leurs parties mobiles ne sont pas en contact. Alternativement, ils sont jointifs.

Selon un exemple, un transducteur électromécanique entoure, au moins partiellement, voire entièrement, un ou plusieurs autres actionneurs électromécaniques, en particulier leur partie mobile. En outre, ils peuvent être actionnés indépendamment les uns des autres.

De préférence, chaque transducteur électromécanique présente une partie mobile configurée de sorte que son mouvement soit fonction dudit changement de pression externe, ou inversement que son mouvement induise un changement de pression externe exercée sur le milieu déformable à travers l'une des parois de la cavité.

Ainsi, le microsystème électromécanique comporte plusieurs transducteurs électromécaniques pour une cavité.

Selon un exemple, au moins certains des transducteurs électromécaniques de ladite pluralité sont configurés pour que, sous sollicitation, leurs parties mobiles, induisent des déformations de la zone libre de la membrane entrainant une inclinaison de l'au moins un pion dans un même sens.

Ainsi, au moins certains de ces transducteurs électromécaniques permettent chacun de déplacer l'au moins un pion selon une même direction et chacun sur une amplitude. L'inclinaison totale du pion résulte du cumul du déplacement des parties mobiles de ces transducteurs électromécaniques. Le microsystème électromécanique présente ainsi un fonctionnement pas à pas ; cela permet de limiter la tension d'adressage.

Les transducteurs électromécaniques peuvent être sollicités simultanément ou successivement. L'amplitude de déplacement du pion induite par chaque transducteur électromécanique peut être identique ou différente.

Selon un exemple, au moins certains des transducteurs électromécaniques de ladite pluralité sont configurés pour que, sous sollicitation, leurs parties mobiles, induisent des déformations de la zone libre de la membrane entrainant une inclinaison de l'au moins un pion dans deux sens opposés.

Ainsi, au moins deux de ces transducteurs électromécaniques permettent de déplacer l'au moins un pion selon deux directions opposées. Ces deux transducteurs électromécaniques sont donc antagonistes. Ainsi, au moins l'un de ces transducteurs électromécaniques permet d'incliner le pion selon un premier sens et au moins un autre de ces transducteurs électromécaniques permet d'incliner le pion selon un deuxième sens opposé au premier sens. Cela permet d'augmenter encore l'amplitude de l'inclinaison possible pour le pion.

Ces deux transducteurs électromécaniques antagonistes peuvent être séparés l'un de l'autre d'une distance non nulle. Alternativement, l'un de ces transducteurs électromécaniques peut entourer, de préférence entièrement, l'autre transducteur électromécanique. Selon un autre mode de réalisation un même transducteur permet d'effectuer ces deux mouvements alternatifs. On pourra pour cela utiliser un transducteur en AIN par exemple.

Selon un exemple, le microsystème électromécanique comprend plusieurs zones libres, séparées les unes des autres d'une distance non nulle.

Ces zones libres peuvent être formées par une même membrane. Alternativement, ces zones libres peuvent être formées par des membranes distinctes.

Selon un exemple, la zone libre est libre de se déformer, de préférence de façon élastique, en fonction dudit changement de pression externe.

Le microsystème électromécanique tel qu'introduit ci-dessus est de préférence exempt d'élément optique, telle qu'une lentille, notamment à focale variable.

Le pion n'est pas fixé au centre de la zone libre de la membrane déformable. De la sorte, le mouvement du pion n'est pas un mouvement de translation perpendiculaire à la paroi de la cavité qui est en partie formée par la membrane déformable.

Au moins une partie du transducteur électromécanique forme une partie de la paroi de la cavité qui est en partie formée par la membrane déformable. Le microsystème électromécanique selon cette caractéristique présente une structure non-traversante, laissant libre les autres parois de la cavité de sorte à pouvoir y réaliser d'autres fonctions ou de sorte à leur permettre de rester inertes, pour une capacité d'intégration accrue notamment dans un microsystème opto-électro-mécanique.

Le transducteur électromécanique peut s'étendre, directement ou indirectement, sur la membrane déformable, et de préférence autour de la zone libre de la membrane déformable. En outre, le transducteur électromécanique peut prendre une forme annulaire dont le centre circulaire défini l'étendue de la zone libre de la membrane déformable.

La partie mobile du transducteur électromécanique peut présenter une surface au moins deux fois supérieure, voire au moins 5 fois supérieure, et de préférence au moins dix fois supérieure à une surface de la zone libre de la membrane déformable, voire à la surface des zones libres de la membrane déformable. Plus la surface du transducteur est importante par rapport à la surface de la zone libre, plus l'amplitude de déformation de la zone libre de la membrane sera importante.

La membrane déformable est de préférence configurée de sorte que sa zone libre soit capable de se déformer avec une amplitude d'au moins 50 µm, voire d'au moins 100µm, voire d'au moins 1000µm selon une direction perpendiculaire au plan dans lequel elle s'étend principalement lorsqu'elle est au repos. Sans se déchirer et/ou sans usure significative, le microsystème électromécanique offre ainsi la capacité à satisfaire de nombreuses et diverses applications nécessitant un grand débattement, ce dernier étant défini le cas échéant par domaine technique concerné.

Selon un exemple, au moins une partie du transducteur électromécanique forme une partie de ladite première paroi de la cavité.

Selon un exemple, le transducteur électromécanique s'étend, directement sur la membrane déformable, c'est-à-dire que le transducteur électromécanique est directement au contact de la membrane déformable. Alternativement, le transducteur électromécanique s'étend indirectement sur la membrane déformable c'est-à-dire qu'au moins un élément ou une couche intermédiaire est disposé entre le transducteur électromécanique et la membrane déformable. De préférence, le transducteur électromécanique s'étend autour de la zone libre de la membrane déformable.

Selon un exemple, le transducteur électromécanique entoure entièrement la zone libre de la membrane déformable, le transducteur électromécanique présentant de préférence une forme annulaire dont le centre circulaire défini l'étendue de la zone libre de la membrane déformable.

Le microsystème électromécanique peut comprendre en outre au moins une butée latérale configurée pour guider le mouvement du pion ou de l'organe externe s'il est présent. Selon un exemple optionnel, la butée latérale est supportée par la paroi de la cavité qui est en partie formée par la membrane déformable. Selon un exemple optionnel, ladite au moins une butée latérale s'étend à l'opposé de la cavité.

Il est ainsi possible de :
- limiter, de manière contrôlée, fiable et reproductible, l'inclinaison du pion lors du mouvement de la partie mobile du transducteur électromécanique, et/ou
- permettre un auto-positionnement de l'organe externe relativement à la zone libre de la membrane déformable, et/ou
- protéger la membrane déformable, et plus particulièrement sa zone libre, notamment d'un éventuel arrachement, lors d'un report ou d'un collage de l'organe externe.

Selon un exemple, la zone libre de la membrane déformable est configurée pour coopérer avec l'organe externe via le pion fixé sur ladite zone libre.

Le pion peut s'étendre depuis la zone libre de la membrane déformable au-delà de ladite au moins une butée latérale.

En alternative, le pion peut s'étendre depuis la zone libre de la membrane déformable en-deçà de ladite au moins une butée latérale. Le microsystème électromécanique selon l'une ou l'autre de ces deux caractéristiques offre une capacité d'adaptation satisfaisante à une large variété d'organes externes et d'applications.

Le microsystème électromécanique peut comprendre en outre une butée dite basse supportée par la paroi de la cavité opposée à la zone libre de la membrane déformable, ladite butée basse s'étendant dans la cavité vers la zone libre. Elle présente une forme et des dimensions configurées pour limiter la déformation de la zone libre de la membrane déformable de sorte à protéger la membrane déformable, et plus particulièrement sa zone libre, notamment d'un éventuel arrachement, lors d'un report ou d'un collage de l'organe externe. Par ailleurs, la butée dite basse est conformée pour limiter la surface de contact entre la membrane et la paroi de la cavité opposée à la zone libre de la membrane déformable. De manière alternative ou cumulée, la butée basse est conformée de sorte à limiter la surface de contact entre la membrane et la paroi de la cavité opposée à la zone libre de la membrane déformable. Cela permet d'éviter que la membrane n'adhère à cette paroi.

Le transducteur électromécanique peut être un transducteur piézoélectrique, de préférence comprenant un matériau piézoélectrique à base de PZT.

Le transducteur électromécanique peut être un transducteur à fonctionnement statique. En alternative ou en complément, le transducteur électromécanique peut être un transducteur à fonctionnement vibratoire à au moins une fréquence de résonance, ladite au moins une fréquence résonance étant de préférence inférieure à 100 kHz, et encore plus préférentiellement inférieure à 1 kHz.

Le milieu déformable contenu hermétiquement dans la cavité peut comprendre au moins l'un parmi un fluide et/ou un liquide, et des microbilles, le fluide présentant de préférence une viscosité de l'ordre de 100 cSt à température et pression ambiantes.

Selon un exemple de réalisation non limitatif, le fluide présente une compressibilité comprise entre 10⁻⁹ et 10⁻¹⁰ Pa⁻¹ à 20°C, par exemple de l'ordre de 10⁻¹⁰ Pa⁻¹ à 20°C, sans que ces valeurs soient limitatives.

Le microsystème électromécanique tel qu'introduit ci-dessus peut comprendre en outre une pluralité de membranes déformables et/ou une pluralité de zones libres par membrane déformable et/ou une pluralité de transducteurs électromécaniques.

Ledit au moins un microsystème optique du système opto-électro-mécanique tel qu'introduit ci-dessus peut comprendre au moins un miroir également désigné micro-miroir, de préférence à base de silicium.

Selon un exemple, le système opto-électro-mécanique est configuré de sorte à ce que le mouvement de la partie mobile du transducteur électromécanique provoque un déplacement de l'au moins un miroir.

On entend, par « microsystème électromécanique », un système comprenant au moins un élément mécanique et au moins un transducteur électromécanique réalisés à l'échelle micrométrique avec des moyens de la microélectronique. Le transducteur électromécanique peut capter un mouvement de l'élément mécanique ; le microsystème électromécanique joue alors le rôle de capteur. En alternative ou en complément, l'élément mécanique peut être mis en mouvement (actionné) grâce à une force générée par le transducteur électromécanique. Le microsystème électromécanique joue alors le rôle d'actionneur ou de dispositif de préhension.

Le transducteur électromécanique peut être alimenté par des tensions électriques produites avec des circuits électroniques avoisinants.

Un « microsystème » est un système dont les dimensions externes sont inférieures à 1 centimètre (10⁻² mètres) et de préférence à 1 millimètre (10⁻³ mètres).

Le plus souvent, un transducteur électromécanique joue un rôle d'interface entre les domaines mécanique et électrique. Toutefois, on entend ici, par « transducteur électromécanique », aussi bien un transducteur piézoélectrique, qu'un transducteur thermique, ce dernier jouant un rôle d'interface entre les domaines mécanique et thermique. Un transducteur électromécanique peut comprendre une partie mobile entre une position d'équilibre, hors sollicitation, et une position hors équilibre, sous sollicitation. Lorsque le transducteur est piézoélectrique, la sollicitation est de nature électrique. Lorsque le transducteur est thermique, la sollicitation est de nature thermique.

Lorsqu'il est fait mention du centre de la cavité, ce centre est défini géométriquement en considérant comme le centre d'une cavité présentant une zone libre non déformée de la membrane déformable.

On entend par « inférieur » et « supérieur », « inférieur ou égal » et « supérieur ou égal », respectivement. L'égalité est exclue par l'usage des termes « strictement inférieur » et « strictement supérieur ».

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

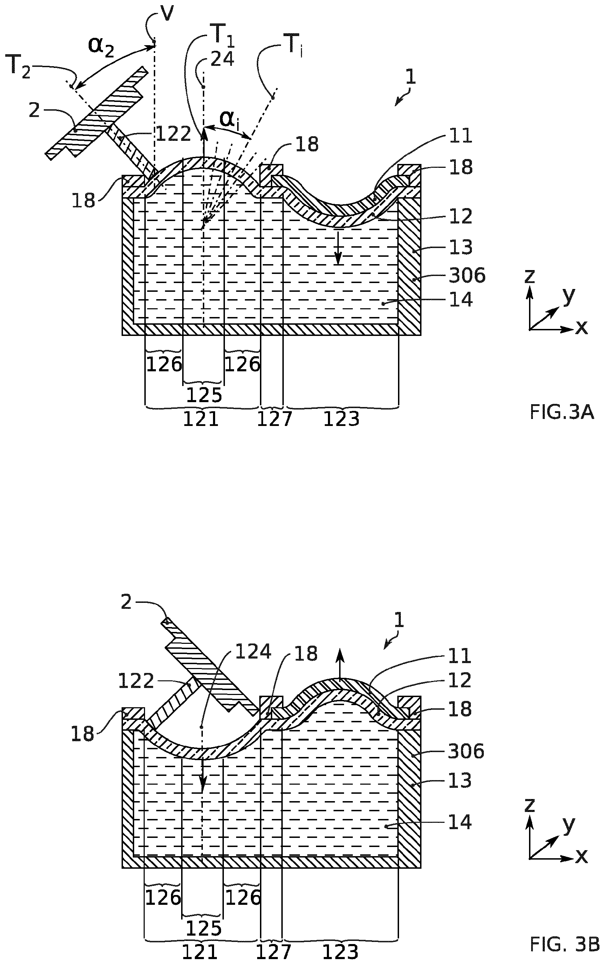

Comme cela sera décrit plus en détail par la suite le microsystème électromécanique 1 selon l'invention peut, selon sa configuration et son utilisation, assurer plusieurs fonctions:
- En tant qu'actionneur, il peut permettre de déplacer un objet tel qu'un organe externe 2 en l'inclinant dans un premier sens, (par exemple vers la gauche) comme illustré sur les figures 3A et 7A, ou dans un deuxième sens (par exemple vers la droite), comme illustré sur les figures 3B et 7B.
- En tant que dispositif de préhension, il peut permettre de capturer ou expulser un objet 3 comme illustré sur la figure 6B, de saisir un objet 3 comme illustré sur la figure 6C, ou encore de retenir un objet 3 déjà capturé comme illustré sur la figure 6D.
- En tant que capteur, il peut permettre de capter un déplacement, en particulier une inclinaison.

Les caractéristiques permettant d'assurer ces différentes fonctions vont maintenant être décrites en détail en référence aux figures.

Les figures 1 et 2 sont des schémas de principe, respectivement d'une vue en coupe et du dessus, d'un exemple de microsystème électromécanique 1 selon l'invention. Les figures 3A et 3B illustrent le microsystème électromécanique des figures 1 et 2, en cours d'utilisation.

En figure 1 sont illustrés un transducteur électromécanique 11, une membrane déformable 12 et une cavité 13 configurée pour contenir hermétiquement un milieu déformable 14.

Avant de décrire plus en détail les différents modes de réalisation de l'invention illustrés sur les figures, notons que chacune de ces illustrations représente schématiquement un mode de réalisation du microsystème électromécanique qui présente une structure non traversante. Plus particulièrement, dans les différents modes illustrés, le transducteur électromécanique 11 et la membrane déformable 12 se situent tous deux en face avant FAV du microsystème électromécanique 1. Ce type de structure est particulièrement avantageux dans la mesure où la face arrière FAR du microsystème électromécanique 1 peut participer uniquement de façon passive, et en particulier sans se déformer, à la fonction d'actionneur et/ou de dispositif préhension et/ou de capteur du microsystème électromécanique 1. Plus particulièrement, la face arrière FAR d'un microsystème électromécanique 1 à structure non traversante selon l'invention peut notamment constituer une face par laquelle le microsystème électromécanique 1 peut être aisément monté sur un support et/ou peut constituer une face par laquelle le microsystème électromécanique peut aisément être davantage fonctionnalisé.

Toutefois, l'invention n'est pas limitée aux microsystèmes électromécaniques à structure non traversante. L'invention concerne également des microsystèmes électromécaniques 1 dits à structure traversante dans lesquels le transducteur électromécanique 11 et la membrane déformable 12 sont agencés sur des parois distinctes entre elles de la cavité 13, que ces parois soient adjacentes ou opposées entre elles.

### Transducteur électromécanique 11

Le transducteur électromécanique 11 comprend au moins une partie mobile 111. Cette dernière est configurée pour se mouvoir ou être mue entre au moins deux positions. Une première de ces positions est une position d'équilibre atteinte et conservée lorsque le transducteur électromécanique 11 n'est pas sollicité, que ce soit par exemple par un courant électrique l'alimentant ou par une force le contraignant hors de sa position d'équilibre. Une deuxième position de la partie mobile 111 du transducteur électromécanique 11 est atteinte lorsque le transducteur électromécanique 11 est sollicité, que ce soit par exemple par un courant électrique l'alimentant ou par une force le contraignant hors de sa position d'équilibre. Le transducteur électromécanique 11 peut être maintenu dans l'une ou l'autre des première et deuxième positions décrites ci-dessus, et présenter ainsi un comportement binaire, ou peut être en outre maintenu dans n'importe quelle position intermédiaire entre sa position d'équilibre et sa position de plus grand éloignement, ou de plus grande déformation, par rapport à l'équilibre.

Dans l'exemple illustré, lorsque le transducteur électromécanique 11 n'est pas sollicité, sa partie mobile 111 s'étend principalement dans un plan parallèle au plan xy du repère orthogonal xyz illustré en figure 1.

Le transducteur électromécanique 11 est de préférence un transducteur piézoélectrique. Chaque transducteur électromécanique 11 comprend au moins un matériau piézoélectrique mécaniquement couplé à un autre élément, qualifié de support ou de poutre. Le terme de poutre ne limite aucunement la forme de cet élément.

De façon connue, un matériau piézoélectrique présente comme propriété de se contraindre lorsqu'on lui applique un champ électrique. En se contraignant, il se déforme. Mécaniquement associé au support, le matériau piézoélectrique entraine le support avec lui et déplace alors ce dernier. La zone du support susceptible de se déplacer correspond à la partie mobile 111. C'est cette propriété de déplacement qui est utilisée pour former un actionneur.

De même, sous l'action d'une contrainte mécanique, un matériau piézoélectrique se polarise électriquement. Ainsi, lorsque le support est déplacé, il déforme le matériau piézoélectrique qui induit un courant électrique. C'est cette propriété qui est utilisée pour former un capteur.

Il ressort donc de cet exemple, mais cela reste potentiellement vrai pour chacun des autres modes de réalisation envisagés du transducteur électromécanique 11, que le microsystème électromécanique 1 selon l'invention peut fonctionner comme actionneur et/ou comme dispositif de préhension et/ou comme capteur.

Le transducteur électromécanique 11 est encore plus préférentiellement un transducteur piézoélectrique comprenant un matériau piézoélectrique à base de PZT (Titano-Zirconate de Plomb). Dans ce cas, la partie mobile 111 du transducteur électromécanique 11 est capable sous sollicitation de se mouvoir avec un déplacement plus significatif (du fait du coefficient piézoélectrique d31) qu'avec bon nombre d'autres matériaux piézoélectriques. Toutefois, le PZT étant un matériau ferroélectrique, un tel transducteur piézoélectrique fonctionne préférentiellement dans un seul sens d'actionnement (mouvement dans un unique sens de sa partie mobile 111) quelle que soit la polarité de son alimentation électrique, alors qu'un transducteur piézoélectrique à base d'un matériau non-ferroélectrique peut préférentiellement fonctionner dans les deux sens (mouvement dans deux sens opposés de sa partie mobile 111). En alternative ou en complément, le transducteur électromécanique 11 peut être un transducteur piézoélectrique (non ferroélectrique) à base d'un matériau propre à permettre à sa partie mobile 111 de se mouvoir dans des sens opposés relativement à sa position d'équilibre, par exemple en fonction de la polarité de son alimentation électrique. Un tel matériau est par exemple un matériau à base de nitrure d'aluminium (AIN).

En alternative ou en complément, le transducteur électromécanique 11 peut être ou comprendre un transducteur thermique.

### Membrane déformable 12

La membrane déformable 12 peut être à base d'un polymère, et est de préférence à base de PDMS. Les propriétés de la membrane déformable 12 en particulier son épaisseur, sa surface et sa forme peuvent être configurées pour conférer à la membrane déformable 12, et plus particulièrement à une zone 121 de cette membrane qui est libre de se déformer, une capacité d'étirement escomptée, notamment en fonction de l'application visée.

### Cavité 13

La cavité 13 peut présenter une symétrie de rotation ou de révolution autour d'un axe z perpendiculaire au plan xy, comme cela est illustré en figure 2. Alternativement, la cavité peut présenter, vue du dessus, une forme polygonale, par exemple comme illustré sur les figures 17A à 17D qui seront décrites en détail par la suite.

La cavité 13 telle qu'illustrée notamment sur les figures 1, 3A et 3B présente plus particulièrement des parois 131, 132, 133 contenant hermétiquement le milieu déformable 14. Dans les exemples illustrés, la paroi 132 de la cavité 13 constitue la face arrière FAR du microsystème électromécanique 1. La paroi 131 opposée à la paroi 132 est formée au moins en partie par au moins une partie de la membrane déformable 12. Ainsi, la paroi 131 est déformable. La paroi 131 peut être désignée par la suite première paroi. Elle se situe au niveau de la face avant FAV du microsystème électromécanique 1. Au moins une paroi 133 latérale joint entre elles les parois 131 et 132. On notera que l'herméticité de la cavité 13 nécessite que la membrane déformable 12 soit elle-même imperméable, ou rendue imperméable, notamment au niveau de sa zone libre 121. De préférence, les parois 132, 133 restent fixes lorsque la membrane se déforme.

Le milieu déformable 14 est quant à lui propre à conserver un volume sensiblement constant sous l'action d'un changement de pression externe. Autrement dit, il peut s'agir d'un milieu incompressible ou faiblement compressible dont la déformation nécessite de préférence peu d'énergie. Il s'agit par exemple d'un liquide.

Du fait qu'une partie au moins de la paroi 131 de la cavité 13 est formée par une partie au moins de la membrane déformable 12, l'on comprend que tout changement de pression externe exercée sur le milieu déformable 14 peut être compensé par une déformation, sensiblement proportionnelle, de la membrane déformable 12, et plus particulièrement de sa zone libre 121 (fonctionnement en tant qu'actionneur ou en tant que dispositif de préhension) et/ou par un déplacement de la partie mobile 111 du transducteur électromécanique 11 (fonctionnement en tant que capteur). Lorsque le transducteur 11 est sollicité, cette compensation est plus particulièrement liée à une conversion du changement de pression externe exercée sur le milieu déformable 14 en un étirement de la membrane déformable 12 ou une relaxation de la membrane déformable 12 déjà étirée. On rappelle que le milieu déformable 14 est de préférence incompressible et que ces contraintes s'effectuent donc de préférence avec une conservation du volume de la cavité 13. L'on comprend que, dans un souci de reproductibilité de l'actionnement ou de la captation de mouvement qu'offre le microsystème électromécanique 1 selon l'invention, il est préférable que toute déformation de la membrane déformable 12 soit élastique, et non plastique, pour garantir le retour dans un même état de moindre étirement, ou de relaxation maximale, de la membrane déformable 12 chaque fois qu'elle n'est plus contrainte.

Comme illustré sur chacune des figures 1, 3A et 3B, le transducteur électromécanique 11 peut former une partie de la première paroi 131 de la cavité 13. Le transducteur électromécanique 11 et la membrane déformable 12 sont ainsi placés d'un même côté de la cavité 13. Les structures présentant cette caractéristique sont avantageusement non traversantes, comme évoqué plus haut.

Sur cet exemple non limitatif, la membrane 12 présente une face interne 12i configurée pour être au contact du milieu déformable 14 et une face externe 12e. La face interne 12i forme une partie de la paroi 131 de la cavité 13. Le transducteur électromécanique 11, plus précisément la partie mobile 111 de ce dernier, présente une face interne 11i tournée au regard, et de préférence au contact de la face externe 12e de la membrane 12. Le transducteur électromécanique 11 présente également une face externe 11e, opposée à la face interne 11i, et tournée vers l'extérieur du microsystème électromécanique 1. Alternativement, on peut prévoir qu'une ou des couches intermédiaires soient disposées entre la face externe 12e de la membrane 12 et la face interne 11i du transducteur électromécanique 11. Le microsystème électromécanique 1 est configuré de sorte que le mouvement de la partie mobile 111 du transducteur électromécanique 11 provoque un déplacement de la membrane 12 et donc de la paroi 131 qui enferme le milieu 14.

On remarquera que, sur chacune des figures 1 à 3B :
- le transducteur électromécanique 11 s'étend sur la membrane déformable 12, et
- la membrane déformable 12 sépare le transducteur électromécanique 11 du milieu déformable 14.

En outre, le transducteur électromécanique 11 peut avantageusement être solidaire de la membrane déformable 12 au moins sur une zone 123 située hors de la zone libre 121, et plus particulièrement sensiblement adjacente à la zone libre 121, de sorte que tout mouvement de la partie mobile 111 du transducteur électromécanique 11 induise, notamment sur cette zone 123, un étirement ou une relaxation de la membrane déformable 12. Ainsi dans l'exemple illustré sur la figure 3A, lorsque le transducteur électromécanique 11 est sollicité de sorte à se déplacer vers le bas (comme illustré sur la figure 3A par la flèche s'étendant depuis le transducteur électromécanique 11), une augmentation de la pression externe exercée sur le milieu déformable 14 est observée, qui induit l'étirement de la membrane déformable 12 vers le haut, i.e. à l'opposé du centre de la cavité 13.

### Milieu déformable 14

Le milieu déformable 14 peut plus particulièrement comprendre au moins l'un parmi un fluide et/ou un liquide. Les paramètres du liquide seront adaptés en fonction des applications visés. L'on s'assure ainsi que tout changement de pression externe exercée sur le milieu déformable 14 induit une déformation sensiblement proportionnelle de la zone libre 121 de la membrane déformable 12. Le fluide peut être constitué, ou à base, d'un liquide, tel que de l'huile, ou peut être constitué, ou à base, d'un polymère. Selon un exemple, le fluide est à base, ou est constituée, de glycérine. L'on s'assure ainsi, en plus d'une déformation sensiblement proportionnelle de la membrane 12 à la déformation du transducteur électromécanique 11, de la capacité du milieu déformable 14 à occuper notamment le volume créé par étirement de la zone libre 121 de la membrane déformable 12 à l'opposé du centre de la cavité 13.

Lorsque le microsystème électromécanique 1 joue le rôle d'actionneur ou de dispositif de préhension, le transducteur électromécanique 11 est sollicité de sorte à exercer un changement de pression externe sur le milieu déformable 14 et induire par-là la déformation de la membrane déformable 12. Inversement, lorsque le microsystème électromécanique 1 joue le rôle de capteur, la déformation de la membrane 12 exerce un changement de pression externe sur le milieu déformable 14 qui induit un déplacement de la partie mobile 111 du transducteur électromécanique 11 et génère par voie de conséquence un signal électrique.

### Pion 122

Comme illustré sur les figures 1 à 3B, le microsystème électromécanique 1 est tel que la zone libre 121 de la membrane déformable 12 est configurée pour coopérer avec au moins un doigt, généralement désignée pion 122. Les termes « doigt » et « pion » peuvent être intervertis. Le terme « pion » ne se limite pas aux pièces de section constante et a fortiori aux pièces cylindriques.

Plus précisément, le pion 122 prend appui sur une face externe 12e de la zone libre 121. De la sorte, la déformation de la zone libre 121 induit, ou est induite par, un mouvement du pion 122. C'est donc par l'intermédiaire de la zone libre 121 de la membrane déformable 12 que le microsystème électromécanique 1 déplace le pion 122 ou capte un mouvement du pion 122. Ainsi, lorsque le microsystème électromécanique 1 joue le rôle d'actionneur ou de dispositif de préhension, l'activation du transducteur électromécanique 11 déforme la membrane 12 ce qui déplace le pion 122. Inversement, lorsque le microsystème électromécanique 1 joue le rôle de capteur, un appui ou une traction imposée au pion 122, par exemple par un organe externe 2, génère sur la membrane 12 une déformation (compression ou traction), ce qui déplace le transducteur électromécanique 11 puis génère in fine un signal qui peut être fonction de ce déplacement.

Dans le cas d'un actionneur ou d'un capteur, le déplacement de l'objet ou la captation du déplacement de l'objet peuvent s'effectuer par l'intermédiaire d'un organe externe 2 qui coopère avec le pion 122.

Le microsystème électromécanique 1 peut comprendre plusieurs pions 122. Les pions 122 d'un même microsystème électromécanique 1, voire les pions 122 d'une même zone libre 121, peuvent présenter des formes et/ou des dimensions différentes. En particulier, les pions peuvent présenter des hauteurs différentes. Cela permet par exemple de s'adapter aux objets que l'on souhaite déplacer, capturer ou dont on souhaite capter, voire mesurer, le déplacement.

### Positionnement du pion 122 sur la membrane 12

Comme illustré sur les +, le pion 122 n'est pas fixé au centre de la zone libre 121 de la membrane déformable 12. Le pion 122 est positionné de manière décentrée sur la zone libre 121.

Plus en détail et comme illustré en figures 1 à 3B par exemple, la zone libre 121 de la membrane 12 présente une portion centrale 125 et une portion périphérique 126 qui s'étend depuis la portion centrale 125 et jusqu'à une bordure, également désigné pourtour externe 129 de la zone libre 121. Sur l'exemple illustré en figures 1 à 3B, la membrane 12 forme un disque. La portion centrale 125 forme également un disque centré sur un centre 124 de la zone libre 121. La portion périphérique 126 forme un anneau entourant la portion centrale 125.

Le pourtour externe 129 est par exemple défini par un capot 18 qui maintient la membrane 12. La membrane 12 est ainsi située entre le capot 18 et le milieu déformable 14. Ce capot 18 s'étend par exemple dans le plan xy. Il présente au moins une ouverture qui définit la zone libre 121. En figures 1 et 2, il apparaît que le capot 18 s'étend sur toute la surface de la cavité 13, en projection sur le plan xy, à l'exception d'une ouverture définissant la zone libre 121 de la membrane 12 et d'une autre ouverture 123 dans laquelle est logée une partie du transducteur électromécanique 11, et notamment sa partie mobile 111. Le capot 18 présente une zone 127 (illustrée notamment sur la figure 1) qui sépare ces deux ouvertures 121 et 123.

Le pion 122 est configuré pour prendre appui sur la portion périphérique 126 de la zone libre 121 de sorte qu'une déformation de la zone libre 121 de la membrane 12 entraine une inclinaison du pion 122.

Selon un exemple, le pion 122 présente une première extrémité 122a en appui, direct ou indirect, sur la face externe 12e de la zone libre 121. Il présente également une deuxième extrémité 122b. Selon un mode de réalisation non limitatif, le pion 122 s'étend, entre sa première extrémité 122a et sa deuxième extrémité 122b, principalement selon une unique direction, qualifiée de direction longitudinale 122c. Par exemple, le pion 122 présente une forme cylindrique ou tubulaire, de section circulaire, ovoïdale ou polygonale. Lorsque la zone libre 121 se déforme, sa direction longitudinale 122c s'incline dans un plan perpendiculaire au plan xy.

Selon un mode de réalisation alternatif, le pion 122 ne présente pas une forme cylindrique. Il peut présenter une forme courbe par exemple. Les caractéristiques et avantages techniques mentionnés ci-dessous restent valables si le pion 122 présente une forme courbe ou autre.

### Inclinaison du pion 122

L'inclinaison du pion 122 va maintenant être décrite en détail en référence aux figures 3A et 3B.

Selon un exemple non limitatif, en l'absence de déformation :
- la zone libre 121 de la membrane 12 s'étend principalement dans le plan xy, dit plan hors déformation, et
- la perpendiculaire à la tangente de la membrane 12, en un point donné de la zone libre 121, s'étend selon une direction T1 perpendiculaire au plan hors déformation.

Lorsque la membrane 12 se déforme, la perpendiculaire à la tangente en un point donné de la portion périphérique 126 de la zone libre 121 s'étend selon une direction Ti, inclinée par rapport à la direction T1, d'un angle αi. L'angle αi est mesuré dans un plan perpendiculaire au plan hors déformation xy. L'angle αi est illustré en figure 3A. En se déformant, la zone libre 121 de la membrane 12 présente généralement une forme de portion de sphère, de dôme ou de cloche à partir de son pourtour externe 129. Ainsi, l'angle αi augmente au fur à mesure que l'on s'éloigne de la portion centrale 125 et que l'on se rapproche du pourtour externe 129.

Sur l'exemple illustré, la direction longitudinale 122c du pion 122 s'étend selon la direction T2 perpendiculaire à la tangente de la membrane au niveau de la prise d'appui de l'extrémité 122a du pion 122 sur la zone libre 121. Ainsi, lorsque la zone libre 121 se déforme, la direction longitudinale 122c du pion 122 s'incline. Sur la figure 3A, la direction longitudinale 122c du pion, lorsque la membrane 12 est déformée, forme un angle α2 avec la direction 122c hors déformation.

On s'aperçoit clairement avec cet exemple schématique, que le microsystème électromécanique 1 proposé permet un débattement angulaire particulièrement élevé pour une déformation donnée de la zone libre 121 de la membrane 12. La solution proposée permet ainsi d'amplifier considérablement le mouvement de l'extrémité 122b du pion 122.

Lorsque le pion 122 est lié à un objet tel qu'un organe externe 2, et que :
- le microsystème électromécanique 1 fait office d'actionneur, cela permet d'amplifier le débattement angulaire imposé à cet organe externe 2, et
- le microsystème électromécanique 1 fait office de capteur, cela permet de capter un déplacement de l'organe externe 2.

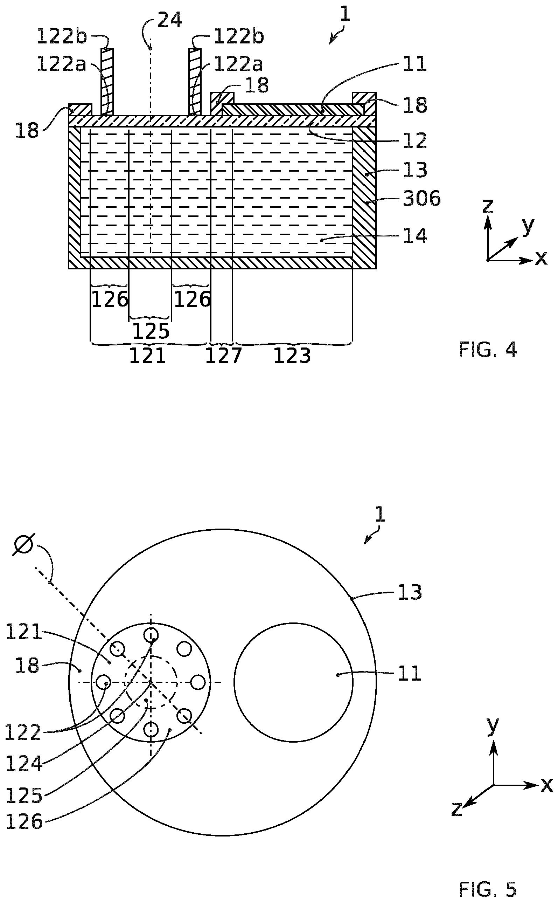

Le microsystème électromécanique 1 proposé procure également de nombreux avantages lorsqu'il fait office de dispositif de préhension. Ces avantages seront décrits en détails par la suite en référence aux figures 4 à 6E.

Un déplacement de la partie mobile 111 du transducteur électromécanique 11 dans un premier sens (ici principalement selon l'axe z) provoque une déformation de la zone libre 121 de la membrane 12 dans un deuxième sens opposé au premier sens, et induit une inclinaison du pion 122 dans un premier sens. Ainsi, comme illustré en figure 3A et en référence au repère xyz, le déplacement vers le bas de la partie mobile du transducteur électromécanique 11 provoque une déformation vers le haut de la zone libre 121 de la membrane 12, et une inclinaison vers la gauche de la direction longitudinale 122c du pion 122. Inversement, comme illustré en figure 3B, un déplacement de la partie mobile 111 du transducteur électromécanique 11 vers le haut provoque une déformation de la zone libre 121 de la membrane 12 vers le bas, et induit une inclinaison de la direction originale 122c du pion 122 vers la droite.

Selon un exemple, et en référence à la figure 1, le pion 122, plus précisément sa première extrémité 122a, est située à une distance minimale D122 d'un point 128 du pourtour externe 129, telle que D122 est inférieure à k fois la distance D124 mesurée entre ce même point 128 et le centre 124 de la zone libre 121.

Le point 128 est le point du pourtour externe 129 le plus proche du pion 122. De préférence, k est inférieur à 0,7, de préférence k est inférieur à 0,5 et de préférence k est inférieur à 0,3. De manière plus générale, plus le pion 122 sera positionné à proximité de la bordure de la zone libre 121, plus l'inclinaison du pion 122 sera importante pour une même déformation de la membrane 12. On augmente ainsi l'amplitude du débattement obtenu.

### Solidarisation du pion 122 et de l'organe externe 2

De façon non limitative, un collage ou une aimantation du pion 122 sur l'organe externe 2 peut permettre de solidariser entre eux le pion 122 et l'organe externe 2. L'énergie d'adhérence du pion 122 sur la zone libre 121 de la membrane déformable 12 est de préférence supérieure à celle du pion 122 sur l'organe externe 2. L'énergie d'adhérence du pion 122 sur la zone libre 121 peut être une résultante d'étapes technologiques ordinaires dans le domaine de la micro-électronique. Cette énergie d'adhérence pouvant ainsi être estimée ou mesurée, il est aisé d'obtenir par collage, par exemple à l'aide d'une résine *ad hoc*, ou par aimantation, par exemple une solidarisation qui soit d'une énergie plus faible que l'énergie avec laquelle le pion 122 est solidarisé avec la membrane déformable 12. On comprend donc que la solidarisation entre le pion 122 et l'organe externe 2 est ainsi largement modulable en termes de force de retenue. Cette modularité peut permettre notamment de rendre amovible la solidarisation entre le pion 122 et l'organe externe 2, par exemple pour permettre à un même microsystème électromécanique 1 selon l'invention d'être agencé successivement avec plusieurs organes externes 2 avec chacun desquels il serait solidarisé, puis désolidarisé.

### Dispositif de préhension : Mode de réalisation illustré en figures 4 à 6E :

En référence aux figures 4 à 6E, un mode de réalisation dans lequel le microsystème électromécanique forme un dispositif de préhension va maintenant être décrit. Toutes les caractéristiques, et tous les effets techniques mentionnés précédemment en référence aux modes de réalisation des figures 1 à 3B restent parfaitement applicables et combinables avec les caractéristiques des modes de réalisation qui vont être décrits en référence aux figures 4 à 6E. En particulier, chacun des modes de réalisation mentionnée précédemment, peuvent présenter plusieurs pions 122 répartis sur la zone libre 121 de la membrane 12.

Le microsystème électromécanique 1 illustré en figures 4 et 5 comprend plusieurs pions 122. De préférence, ces pions 122 sont disposés dans la zone périphérique 126 de la zone libre 121 de la membrane 12. Le microsystème électromécanique 1 est conformé de sorte que les extrémités 122b des pions 122 se rapprochent mutuellement, ou s'éloignent les unes des autres en fonction de la déformation de la zone libre 121.

Comme illustré en figure 6A, lorsque la partie mobile 111 du transducteur électromécanique 11 s'enfonce dans le milieu déformable 14, la zone libre 121 se déforme en s'éloignant du milieu déformable 14 et les extrémités libres 122b des pions 122 s'éloignent les unes des autres. Il est alors possible d'accueillir ou capturer un objet 3 entre les pions 122, comme illustré en figure 6B.

À l'inverse, comme illustré en figures 6C à 6E, lorsque la partie mobile 111 du transducteur électromécanique 11 s'éloigne du milieu déformable 14, la zone libre 121 se déforme en se rapprochant du milieu déformable 14 ou en s'enfonçant dans ce dernier. Les extrémités libres 122b des pions 122 se rapprochent alors les unes des autres.

Il est alors possible de saisir un objet 3, par exemple entre les extrémités 122b, comme illustré en figure 6C. Cela permet par exemple d'effectuer ensuite une étape de traitement de l'objet 3, par un équipement approprié. Ce traitement peut comprendre la modification de l'objet 3, par exemple en lui appliquant un revêtement. Ce traitement peut également comprendre une étape d'analyse de l'objet 3, l'analyse pouvant par exemple être optique, biologique ou encore chimique.

Comme illustré en figure 6D, le rapprochement des extrémités libres 122b des pions 122 permet également d'enfermer l'objet 3 entre le pion 122 et la membrane 12. Le rapprochement de leurs extrémités libres 122b permet de former une cage retenant un objet 3 dont la dimension minimale est supérieure à l'espace entre deux pions 122 adjacents. On peut ensuite prévoir de déplacer cet objet 3. Ce mode de réalisation peut par exemple trouver comme application le tri d'objets.

Comme illustré en figure 6E, en fonction de la dimension des pions 122 et de la dimension de la membrane 12, on peut prévoir que les extrémités libres 122b, viennent en contact les unes avec les autres. Ce mode de réalisation, permet par exemple de saisir des objets de très petite taille, tels que des objets millimétriques, voire micrométriques.

Pour ces modes de réalisation dans lesquels on souhaite saisir / capturer/ enfermer / relâcher un objet 3 entre les pions 122, on prévoit au minimum deux pions 122. De préférence, on prévoit un nombre de pions supérieur à deux. Ce nombre de pions 122 est adapté en fonction de la taille de l'objet 3 que l'on cherche à retenir.

De préférence, les pions sont disposés de manière régulière sur la portion périphérique 126 de la zone libre 121 de la membrane 12.

Sur l'exemple illustré en figure 5, huit pions 122 sont disposés sur la zone périphérique 126. Ces pions sont disposés deux à deux de manière symétrique par rapport au centre 124 de la zone libre 121.

Plus généralement, ces pions 122 sont disposés de manière symétrique par rapport à un sommet de la membrane 12 dans son état de déformation maximale. Typiquement, les pions 122 sont disposés sur un même diamètre Ø de la zone libre 121. Cela est illustré en figure 5. De préférence, le nombre de pions 122 est supérieur à deux. De préférence, il est supérieur à trois. Les pions 121 sont de préférence disposés de manière régulière autour de la portion centrale 125 de la zone libre 121.

Un autre usage du microsystème électromécanique comprenant au moins deux pions consiste en l'étirement d'un objet déformable. Un tel objet pourrait par exemple être une membrane déformable (distincte de la membrane déformable 12), qui serait attachée sur les au moins deux pions, de sorte que le déplacement d'au moins un d'entre eux, ou de plusieurs d'entre eux dans des directions différentes, voire opposées, étire la membrane déformable. De préférence, ces au moins deux pions sont disposés de façon symétrique par rapport au centre de la zone libre 121 de la membrane déformable 12.

Selon un exemple alternatif, les pions 122 ne sont pas répartis de manière symétrique et/ou ne sont pas répartis de manière régulière sur la portion périphérique 126.

### Mode de réalisation des figures 7A et 7B

En référence aux figures 7A à 7C d'autres modes de réalisation vont maintenant être décrits.

Ces autres modes de réalisation diffèrent des précédents par l'agencement de la zone libre 121 par rapport au transducteur électromécanique 11. Toutes les autres caractéristiques mentionnées ci-dessus en référence aux modes de réalisation précédents restent parfaitement applicables et combinables aux modes de réalisation illustrés en figures 7A et 7B. De même, toutes les caractéristiques et valeurs numériques mentionnées ci-dessous sont parfaitement applicables et combinables aux modes de réalisation décrits précédemment. En particulier, par souci de simplification, un seul pion 122 est représenté sur cet exemple. Naturellement, le microsystème électromécanique 1 peut comprendre plus d'un pion 122.

### Agencement de la zone libre 121

Dans les modes de réalisation précédents, la zone libre 121 est séparée du transducteur électromécanique 11. Ainsi, une distance non nulle sépare la zone libre 121 et le transducteur électromécanique 11. Cette distance non nulle est par exemple matérialisée par une zone 127 du capot 18, comme illustré en figure 1.

Dans les modes de réalisation des figures 7A à 7C, la zone libre 121 est entourée, au moins partiellement, par au moins un transducteur électromécanique 11. Comme illustré en 7A à 7C, le transducteur électromécanique 11 entoure entièrement la zone libre 121. Le transducteur électromécanique 11 et la zone libre 121 peuvent alors être jointifs.

Plus précisément, comme illustré sur la figure 7C, le transducteur électromécanique 11 prend la forme d'un anneau d'étendue radiale notée R2 et définit une zone libre 121 circulaire de rayon noté R1. Notons que le transducteur électromécanique 11 n'est pas limité à une forme annulaire, mais peut prendre d'autres formes, et notamment une forme oblongue ou ovale, une forme triangulaire rectangulaire, etc. définissant une pluralité correspondante de formes de la zone libre 121 de la membrane déformable 12. Cette illustration vaut en particulier pour une structure à symétrie de rotation ou de révolution. Néanmoins, une illustration correspondante pour une structure symétrique par rapport à un plan perpendiculaire et centré par rapport à la surface de la zone libre 121 pourrait pareillement être fournie qui consisterait notamment en la représentation de trois bandes adjacentes deux à deux dont la bande centrale représenterait la zone libre 121 de la membrane déformable 12 et dont les bandes latérales représenteraient la partie mobile du ou des transducteurs électromécaniques 11 impliqués.

Notamment lorsque le recouvrement partiel de la membrane déformable 12 par le transducteur électromécanique 11 est tel qu'illustré sur la figure 7C et que le transducteur électromécanique 11 est un transducteur piézoélectrique comprenant un matériau piézoélectrique à base de PZT, il est intéressant que la partie mobile 111 du transducteur électromécanique 11 présente une surface au moins deux fois supérieure, voire au moins 5 fois supérieure, et de préférence au moins dix fois supérieure à la surface de la zone libre 121 de la membrane déformable 12. La membrane déformable 12 est dès lors configurée de sorte que sa zone libre 121 est capable de se déformer avec une amplitude d'au moins 50 µm, par exemple sensiblement égale à 100 µm, voire de plusieurs centaines de µm. De manière générale, la membrane déformable 12 est configurée de sorte que sa zone libre 121 est capable de se déformer avec une amplitude inférieure à 1 mm. Cette déformation est mesurée selon une direction perpendiculaire au plan dans lequel s'étend principalement la face externe 12e de la membrane 12 au repos. Sans se déchirer et/ou sans usure significative, le microsystème électromécanique 1 permet une amplification hydraulique de l'action et offre ainsi la capacité à satisfaire de nombreuses et diverses applications nécessitant un grand débattement. Dans ce contexte, le microsystème électromécanique 1 illustré sur les figures 7A à 7C peut être défini comme un actionneur à grand débattement angulaire.

Le microsystème électromécanique 1 illustré en figure 7A permet une inclinaison du pion 122 vers la gauche lorsque le transducteur électromécanique 11 est sollicité. Le microsystème électromécanique 1 illustré en figure 7B permet une inclinaison du pion 122 vers la droite lorsque le transducteur électromécanique 11 est sollicité.

Egalement lorsque le recouvrement partiel de la membrane déformable 12 par le transducteur électromécanique 11 est tel qu'illustré sur la figure 7C et que le transducteur électromécanique 11 est un transducteur piézoélectrique comprenant un matériau piézoélectrique à base de PZT, mais en référence aux figures 8A et 8B discutées plus en détails ci-dessous, le transducteur électromécanique 11 peut plus particulièrement comprendre un support 305, également désigné poutre 305, et un élément piézoélectrique 302 à base de PZT, ce dernier étant configuré pour induire une déformation du support 305. Le terme poutre 305 ne limite pas la forme du support 305. Dans cet exemple, la poutre 305 forme un anneau. L'épaisseur de l'élément piézoélectrique 302 peut être sensiblement égale à 0,5 µm et l'épaisseur de la poutre 305 est par exemple comprise entre quelques µm et plusieurs dizaines de µm, par exemple sensiblement égale à 5 µm.

Toujours lorsque le recouvrement partiel de la membrane déformable 12 par le transducteur électromécanique 11 est tel qu'illustré sur la figure 7C et que le transducteur électromécanique 11 est un transducteur piézoélectrique comprenant un matériau piézoélectrique à base de PZT, le rayon R1 de la zone libre 121 de la membrane déformable 12 peut être sensiblement égal à 100 µm et l'étendue radiale R2 du transducteur électromécanique 11 (typiquement son rayon s'il est circulaire) peut être sensiblement égal à 350 µm. Les références R1 et R2 sont illustrées en figure 7C. Dans une telle configuration, la partie mobile 111 du transducteur électromécanique 11 peut être déplacée ou défléchie avec une amplitude par exemple sensiblement égale à 15 µm en étant parcouru par une tension électrique par exemple sensiblement égale à 10 V pour une épaisseur de poutre 305 sensiblement égale à 5 µm et une épaisseur de PZT sensiblement égale à 1 µm.

L'invention n'est toutefois pas limitée aux différentes valeurs spécifiques données ci-dessus qui peuvent être largement adaptées, en fonction de l'application visée, notamment pour trouver un compromis entre facteur d'étirement et amplitude de déformation attendue de la zone libre 121 de la membrane déformable 12.

A noter que, dans sa position d'équilibre, la partie mobile 111 du transducteur électromécanique 11, et plus généralement le transducteur électromécanique 11, peut ne pas être plat, mais peut au contraire être convexe ou concave à l'équilibre, ce qui n'enlève rien, en termes d'amplitude, à la capacité de déplacement ou de déflection du transducteur électromécanique 11 alimenté électriquement.

Notons que, notamment lorsque le transducteur électromécanique 11 est un transducteur piézoélectrique, le transducteur électromécanique 11 peut avantageusement être un transducteur à fonctionnement vibratoire. Sa fréquence de résonance est alors de préférence inférieure à 100 kHz, et encore plus préférentiellement inférieures à 1 kHz. La dynamique vibratoire ainsi obtenue peut permettre d'atteindre des débattements plus grands qu'en fonctionnement statique, notamment en exploitant le phénomène de résonnance afférent ou de diminuer la consommation du microsystème électromécanique pour un débattement donné.

### Butées latérales

Le microsystème électromécanique 1 peut comprendre en outre une ou plusieurs butées latérales 15 formant une butée de fin de course pour le pion 122 ou pour l'éventuel organe externe 2 que le pion 122 supporte. La ou les butées latérales 15 sont supportées par la première paroi 131 de la cavité 13. Les figures 7A et 7B illustrent un tel mode de réalisation. Dans ce mode de réalisation, la zone libre 121 de la membrane 12 est entourée par la partie mobile 111 du transducteur électromécanique 11. Chaque butée latérale 15 s'étend plus particulièrement à l'opposé de la cavité 13. Par exemple, chaque butée latérale 15 s'étend depuis une partie non mobile du transducteur électromécanique 11.

Dans les exemples illustrés sur les figures 7A et 7B, chaque butée latérale 15 peut en outre avoir une action de maintien en position d'une partie non mobile du transducteur électromécanique 11, ladite partie non mobile étant complémentaire de la partie mobile 111 du transducteur électromécanique 11. En ce sens, la ou les butées latérales 15 se confondent avec le capot 18. Par exemple, comme illustré sur les figures 8A et 8B, l'action de maintien de la partie non mobile du transducteur électromécanique 11 peut plus particulièrement être assurée par sa mise en prise entre les deux butées latérales 15 et/ou le capot 18, et notamment celle située vers une partie centrale du microsystème 1, et l'espaceur 306, tel qu'introduit ci-dessous, qui matérialise la paroi 133 latérale de la cavité 13 ; en ce sens, l'espaceur 306 s'étend de préférence vers la partie centrale du microsystème 1 au moins jusqu'au droit de la partie du capot 18 la plus proche de la partie centrale du microsystème 1.

Relativement à cette ou ces butées latérales 15, le pion 122 peut s'étendre, à l'opposé de la cavité 13. La ou les butées latérales 15 contribuent à limiter le débattement angulaire du pion 122, et de l'éventuel organe externe 2 associé au pion 122.

Cela permet également de réduire le risque d'arrachement de la membrane déformable 12 lors du report de l'organe externe 2 sur le microsystème électromécanique 1. Naturellement, pour cela, il est préférable que les dimensions de l'organe externe 2 soient configurées pour que ce dernier vienne en butée sur les butées latérales 15 lors de sa fixation sur le pion 122. Naturellement, il conviendrait d'adapter les dimensions et les formes des butées 15 et de l'organe externe 2 pour que ce dernier viennent en butée sur la butée latérale 15 située à droite du microsystème électromécanique.

Notons ici que, dépendant de l'étendue de l'organe externe 2, les butées latérales 15 peuvent également jouer le rôle de butée haute limitant le rapprochement de l'organe externe 2 vers le microsystème électromécanique 1. Cette particularité peut également permettre d'induire une désolidarisation du pion 122 et de l'organe externe 2 entre eux en tirant le pion 122 dans une position plus basse que celle possiblement atteinte par l'organe externe 2 du fait que ce dernier bute sur le haut des butées latérales 15. Plus précisément, les butées latérales 15 présentent une surface de butée configurée pour stopper le déplacement de l'organe 2. Le microsystème électromécanique 1 est configuré de sorte à ce que lorsque le déplacement de l'organe 2 est stoppé dans son déplacement, selon un sens donné, par les butées latérales 15, le pion 122 peut poursuivre son déplacement, dans ce même sens. Le pion 122 se désolidarise ainsi de l'organe 2.

### Butée basse

Comme illustré sur chacune des figures 7A et 7B, le microsystème électromécanique 1 peut comprendre en outre une ou plusieurs butées de fin de course, dites butées basses 16. Cette ou ces butées basses 16 sont supportées par la paroi 132 de la cavité 13 qui est opposée à la paroi 131 formée au moins en partie par la membrane déformable 12. Elle s'étend dans la cavité 13 vers la zone libre 121 de la membrane déformable 12. Cette butée basse 16 présente de préférence une forme et des dimensions configurées pour limiter la déformation de la zone libre 121 de la membrane déformable 12 de sorte à protéger la membrane déformable 12, et plus particulièrement sa zone libre 121, d'un éventuel arrachement, notamment lors du report du pion 122 ou de l'organe externe 2 sur le microsystème électromécanique 1. De manière alternative ou cumulée, la butée basse 16 est conformée de sorte à limiter la surface de contact entre la membrane 12 et la paroi 132 de la cavité 13 opposée à la zone libre 121 de la membrane 12 déformable. Cela permet d'éviter que la membrane 12 n'adhère et ne se colle à cette paroi 132.

Des modes de réalisation de l'invention plus spécifiques que ceux décrits ci-dessus sont illustrés sur les figures 8A et 8B sur lesquelles les mêmes références que sur les figures 7A et 7B référencient les mêmes objets.

On y observe tout d'abord que chaque transducteur électromécanique 11 illustré comprend un support 305, également désigné poutre 305, et un matériau piézoélectrique 302 configuré pour déformer le support 305 lorsqu'une tension électrique lui est appliquée. Le terme poutre 305 ne limite pas la forme de ce support. Dans cet exemple, la poutre 305 forme un anneau.

Une comparaison entre les figures 8A et 8B montre que le matériau piézoélectrique 302 peut être situé d'un côté ou de l'autre de la fibre neutre de l'ensemble constituant la poutre 305. C'est grâce à cette alternative qu'un matériau piézoélectrique dont la déformation est insensible à la polarisation du courant électrique le parcourant permet tout de même de déformer la poutre 305 dans un sens ou dans l'autre.

Plus particulièrement, sur la figure 8A, le matériau piézoélectrique 302 est situé sous la poutre 305, et donc sous la fibre neutre de l'ensemble, c'est-à-dire qu'il est situé entre la poutre 305 et la membrane 12. Lorsqu'un courant électrique parcourt le matériau piézoélectrique 302, il se rétracte et entraîne avec lui la poutre 305. Une extrémité libre 305a de la poutre se courbe vers le bas, entrainant avec elle une partie de la membrane 12 liée à la poutre 305. Par conservation de volume, la zone libre 121 de la membrane se déplace quant à elle vers le haut, entrainant alors avec elle le déplacement vers le haut du pion 122 et son inclinaison, ici vers la gauche. Ce cas de figure correspond à celui illustré en figure 7A. Une autre extrémité 305b de la poutre 302 reste de préférence fixe. Cette autre extrémité 305b, est par exemple solidaire d'une paroi fixe 306 de la cavité 13 et des éventuelles butées latérales 15. Selon un autre mode de réalisation, on peut prévoir que l'extrémité 305b soit fixée à un capot du microsystème électromécanique 1. Le capot ou la cavité du microsystème électromécanique 1 est destiné à être fixé sur un support ou un bâti.

Sur la figure 8B, le matériau piézoélectrique 302 est situé au-dessus de la poutre 305 c'est-à-dire que la poutre 305 est située entre le matériau piézoélectrique 302 et la membrane 12. Lorsqu'un courant électrique parcourt le matériau piézoélectrique 302, il se rétracte et entraîne avec lui la poutre 305. Une extrémité libre 305a de la poutre fléchit alors vers le haut, tirant avec elle la partie de la membrane 12 liée à la poutre 305. Par conservation de volume, la zone libre 121 de la membrane se déplace quant à elle vers le bas, entrainant alors avec elle le déplacement vers le bas du pion 122 et son inclinaison, ici vers la droite. Ce cas de figure correspond à celui illustré en figure 7B.

On observe également sur les figures 8A et 8B, les différentes hauteurs que peuvent présenter le pion 122 relativement à la hauteur des butées latérales 15. On n'y observe encore que les butées latérales 15 et les butées basses 16 peuvent prendre différentes formes, et notamment une forme parallélépipédique, une forme tronconique, une forme sensiblement pyramidale, etc.

On observe en outre, sur les figures 8A et 8B, que la partie mobile 111 du transducteur électromécanique 11 peut être sensiblement définie par l'étendue du matériau piézoélectrique 302 relativement à l'étendue de la poutre 305.

Sur les figures 8A et 8B, des ouvertures d'accès pour une connexion électrique des électrodes sont représentées. Ces ouvertures forment dans ces exemples des via 17 à travers le capot 18. Dans cet exemple, les vias 17 traversent toute l'épaisseur de la poutre 305. L'épaisseur e₃₀₅ de la poutre 302 est mesurée selon une direction perpendiculaire au plan dans lequel s'étend principalement les faces 12e et 12i de la membrane 12. L'épaisseur e₃₀₅ est référencée en figures 8A et 8B.

Les figures 8A et 8B illustrent plus particulièrement des troisième et quatrième modes de réalisation de l'invention qui ont été obtenus par des étapes de dépôt et de gravure pouvant être qualifiées comme ordinaires dans le domaine de la microélectronique. Plus particulièrement, le microsystème électromécanique 1 selon le troisième mode de réalisation illustré sur la figure 8A a été obtenu par la succession d'étapes illustrées par les figures 9A, 10A, 11A, 12A, 13A, 14A et 15A et le microsystème électromécanique 1 selon le quatrième mode de réalisation illustré sur la figure 8B a été obtenu par la succession d'étapes illustrées par les figures 9B, 10B, 11B, 12B, 13B, 14B et 15B. Ainsi, deux procédés de fabrication sont illustrés qui mènent chacun à l'un des microsystèmes électromécaniques 1 illustrés sur les figures 8A et 8B.

Ces procédés de fabrication ont au moins en commun de comprendre :
- une étape de formation de ce qui est destiné à constituer une portion au moins du transducteur électromécanique 11 sur un substrat 200, puis
- une étape de dépôt de la membrane déformable 12, puis
- une étape de formation d'une cavité 13 ouverte sur la membrane déformable 13, puis
- une étape de remplissage avec le milieu déformable et de fermeture de la cavité 13, et
- une étape de gravure du substrat 200 pour former la face avant des microsystèmes électromécaniques illustrés sur les figures 8A et 8B.

### Exemples d'étapes de procédés de fabrication

Nous décrivons ci-dessous successivement chacun des procédés de fabrication susmentionnés, en commençant par le procédé de fabrication du microsystème électromécanique 1 tel qu'illustré sur la figure 8A.

La première étape de ce procédé est illustrée sur la figure 9A. Elle consiste à fournir un substrat 200 sur lequel un empilement de couches s'étend qui peut comprendre successivement, depuis une face du substrat 200 :
- une première couche isolante 201, par exemple à base d'oxyde de silicium, pouvant être déposée par dépôt chimique en phase vapeur assisté par plasma (ou PECVD, pour Plasma-Enhanced Chemical Vapor Déposition en anglais),
- une couche 202 destinée à constituer la poutre 305 du transducteur électromécanique 11, cette couche 202 étant par exemple à base de silicium amorphe et pouvant être déposée par dépôt chimique en phase vapeur (ou CVD pour l'anglais chemical vapor déposition) à pression sous-atmosphérique (ou LPCVD) ou par utilisation d'une structure de type SOI (pour Silicon On Insulator ou, en français, silicium sur isolant),
- une deuxième couche isolante 203, par exemple à base d'oxyde de silicium et pouvant être déposée par PECVD,
- une couche 204 destinée à constituer une électrode dite inférieure, par exemple à base de platine et pouvant être déposée par dépôt physique en phase vapeur (ou PVD pour l'anglais physical vapor déposition),
- une couche 205 en un matériau piézoélectrique, par exemple à base de PZT, et pouvant être déposée par un procédé sol gel, et
- une couche 206 destinée à constituer une électrode dite supérieure, par exemple à base de platine et pouvant être déposée par PVD.

La deuxième étape du procédé de fabrication du microsystème électromécanique 1 tel qu'illustré sur la figure 8A est illustrée sur la figure 10A. Elle comprend :
- une gravure de la couche 206 de sorte à former l'électrode supérieure 301 du transducteur électromécanique 11,
- une gravure de la couche 205 de sorte à former les éléments piézoélectriques 302 du transducteur électromécanique 11, et
- une gravure de la couche 204 de sorte à former l'électrode inférieure 303 du transducteur électromécanique 11.

Notons que chacune de ces gravures peut être réalisée par lithographie, et préférentiellement par gravure au plasma, ou par voie chimique humide.

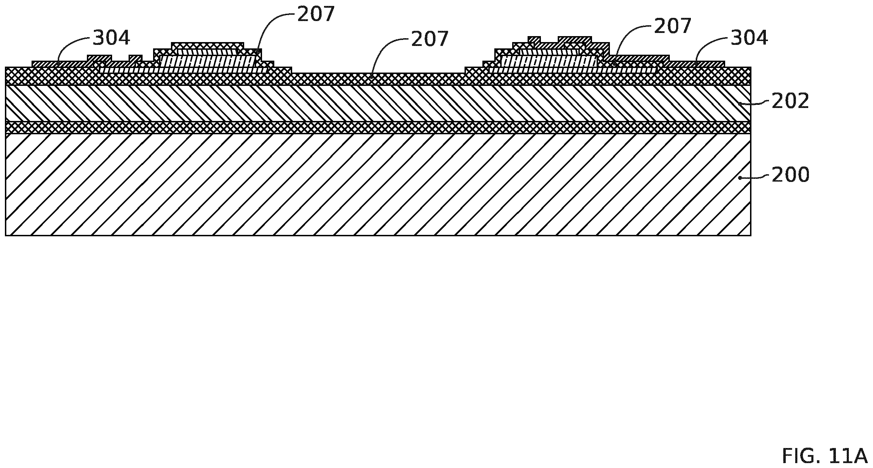

La troisième étape du procédé de fabrication du microsystème électromécanique 1 tel qu'illustré sur la figure 8A est illustrée sur la figure 11A. Elle comprend :
- le dépôt d'une couche de passivation 207, par exemple à base d'oxyde de silicium et/ou de nitrure de silicium, pouvant être déposée par PECVD,
- l'ouverture, à travers la couche de passivation 207, d'une zone de reprise de contact par électrode, cette ouverture étant réalisée par exemple par lithographie, et préférentiellement par gravure au plasma, ou par voie chimique humide,
- le dépôt d'une couche destinée à constituer une ligne électrique 304 par électrode, la couche étant par exemple à base d'or et pouvant être déposée par PVD, et
- une gravure de la couche précédemment déposée de sorte à former une ligne électrique 304 par électrode, cette gravure étant réalisée par exemple par lithographie, et préférentiellement par gravure au plasma, ou par voie chimique humide.

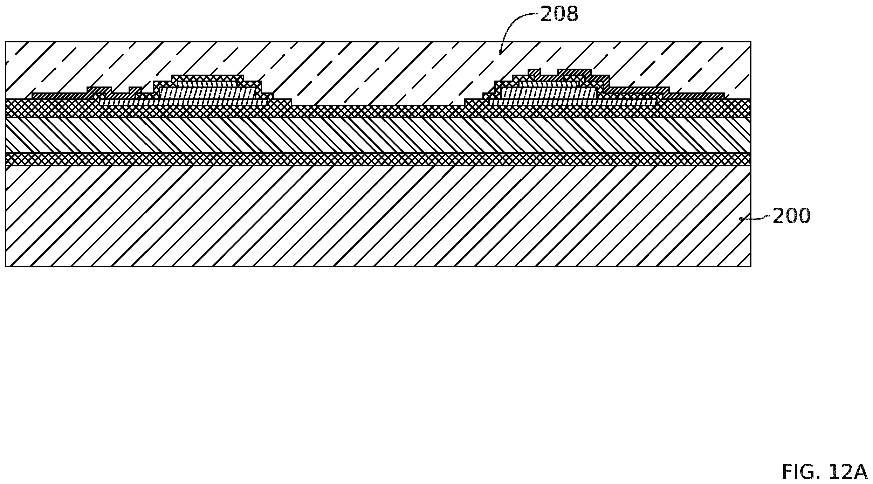

La quatrième étape du procédé de fabrication du microsystème électromécanique 1 tel qu'illustré sur la figure 8A est illustrée sur la figure 12A. Elle comprend le dépôt d'une couche 208 à base d'un polymère et destinée à constituer la membrane déformable 12. Cette couche 208 est par exemple déposée par enduction centrifuge (ou *spin coating* en anglais). Le polymère à base duquel la couche 208 est constituée est par exemple à base de PDMS.

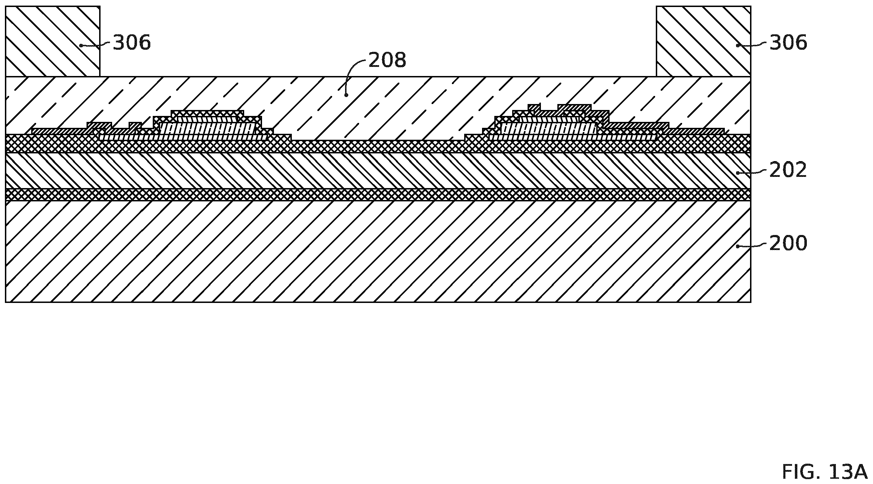

La cinquième étape du procédé de fabrication du microsystème électromécanique 1 tel qu'illustré sur la figure 8A est illustrée sur la figure 13A. Elle comprend la formation d'au moins un espaceur 306 destiné à constituer au moins une partie de ladite au moins une paroi 133 latérale de la cavité 13. La formation du ou des espaceurs peut comprendre le laminage d'un matériau photosensible à base duquel le ou les espaceurs sont constitués, l'insolation, puis le développement du matériau photosensible. Ledit matériau photosensible peut être à base d'un polymère, et notamment à base de Siloxane. Le laminage du matériau photosensible peut comprendre le laminage d'un film sec dudit matériau.

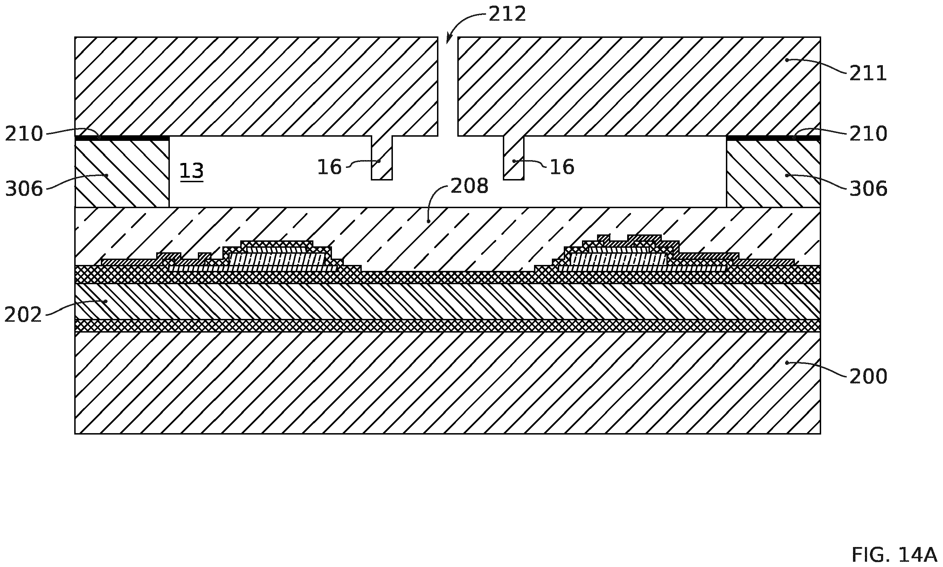

La sixième étape du procédé de fabrication du microsystème électromécanique 1 tel qu'illustré sur la figure 8A est illustrée sur la figure 14A. Selon un mode de réalisation optionnelle, cette étape comprend le dépôt de colle 210 au sommet de chaque espaceur 306, ce dépôt pouvant être réalisé par sérigraphie ou par dispense. Elle comprend la fixation, par exemple le collage, sur le sommet du ou des espaceurs (éventuellement par l'intermédiaire de la colle 210), d'un second substrat 211 pouvant être structuré de sorte à comprendre au moins l'un parmi un évent traversant 212 et une butée basse 16 telle que décrite ci-dessus. Dans un mode de réalisation alternatif, selon la nature de l'espaceur, celui-ci peut jouer le rôle de colle. À l'issue de cette sixième étape, la cavité 13 est formée qui est ouverte par au moins un évent traversant 212.

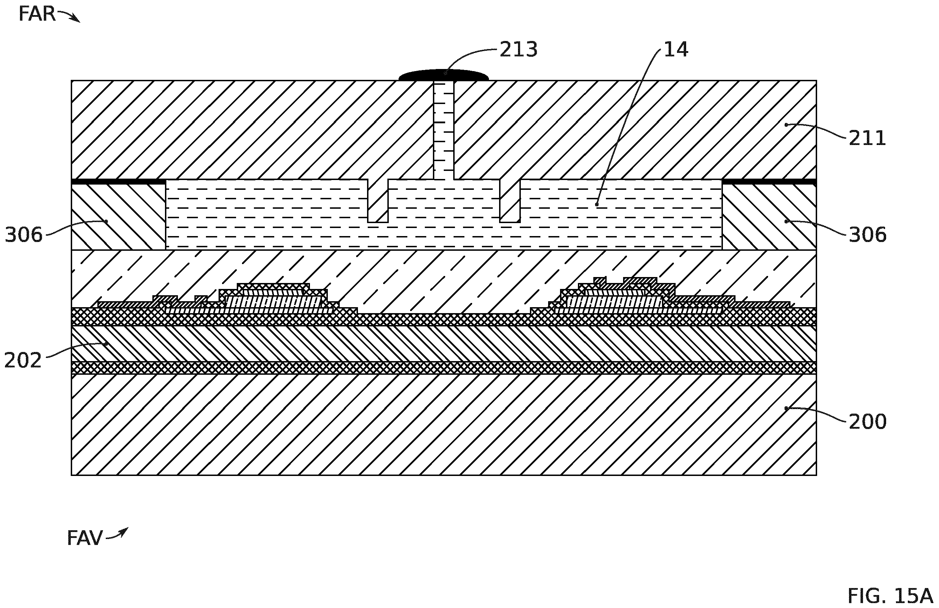

La septième étape du procédé de fabrication du microsystème électromécanique 1 tel qu'illustré sur la figure 8A est illustrée sur la figure 15A. Elle comprend le remplissage, de préférence sous vide, de la cavité 13 avec le milieu déformable 14 tel que décrit ci-dessus, par exemple par dispense à travers l'évent traversant 212. Elle comprend également la fermeture étanche de l'au moins un évent traversant 212, par exemple par dispense d'un matériau de scellement 213 à l'embouchure de chaque évent traversant 212, le matériau de scellement 213 étant par exemple à base d'une colle époxy.

Une étape additionnelle permet d'obtenir le microsystème électromécanique 1 tel qu'illustré sur la figure 8A. Elle comprend la gravure du substrat 200. Cette gravure peut être réalisée par lithographie, et préférentiellement par gravure au plasma, ou par voie chimique humide. Elle comprend ensuite la gravure de la couche 202 et des couches isolantes 201, 203 de sorte à former au moins une poutre 305 du transducteur électromécanique 11, à exposer une partie de la membrane déformable 12 et à constituer tout ou partie du pion 122 et des éventuelles butées latérales 15.

Notons que, suite aux étapes décrites ci-dessus de fabrication du microsystème électromécanique 1 tel qu'illustré sur la figure 8A, le pion 122 prend la forme d'un empilement s'étendant directement depuis la membrane déformable 12 à l'opposé de la cavité 13 en présentant successivement le matériau de la couche isolante 201, le matériau constituant la poutre 305, le matériau de la couche isolante 203 et le matériau constituant le substrat 200. On constate que le pion 122 n'est pas centré sur la zone libre 121.

Notons également que, suite aux étapes décrites ci-dessus de fabrication du microsystème électromécanique 1 tel qu'illustré sur la figure 8A, les éventuelles butées latérales 15 prennent chacune la forme d'un empilement s'étendant, directement ou indirectement, depuis la membrane déformable 12 à l'opposé de la cavité 13 en présentant successivement le matériau de la couche isolante 201, le matériau constituant la poutre 305, le matériau de la couche isolante 203 et le matériau constituant le substrat 200.

Le procédé de fabrication du microsystème électromécanique 1 tel qu'illustré sur la figure 8B est décrit ci-dessous.

La première étape de ce procédé est illustrée sur la figure 9B. Elle consiste à fournir un substrat 400 sur lequel un empilement de couches s'étend qui peut comprendre successivement, depuis une face du substrat 400 :
- une première couche isolante 401, par exemple à base d'oxyde de silicium, pouvant être déposée par dépôt chimique en phase vapeur assisté par PECVD,
- une couche 402 destinée à constituer une électrode dite inférieure, par exemple à base de platine et pouvant être déposée par PVD,
- une couche 403 en un matériau piézoélectrique, par exemple à base de PZT, et pouvant être déposée par un procédé sol gel, et
- une couche 404 destinée à constituer une électrode dite supérieure, par exemple à base de platine et pouvant être déposée par PVD.

La deuxième étape du procédé de fabrication du microsystème électromécanique 1 tel qu'illustré sur la figure 8B est illustrée sur la figure 10B. Elle comprend :
- une gravure de la couche 404 de sorte à former l'électrode supérieure 301 du transducteur électromécanique 11,
- une gravure de la couche 403 de sorte à former les éléments piézoélectriques 302 du transducteur électromécanique 11, et
- une gravure de la couche 402 de sorte à former l'électrode inférieure 303 du transducteur électromécanique 11.

Notons que chacune de ces gravures peut être réalisée par lithographie, et préférentiellement par gravure au plasma, ou par voie chimique humide.

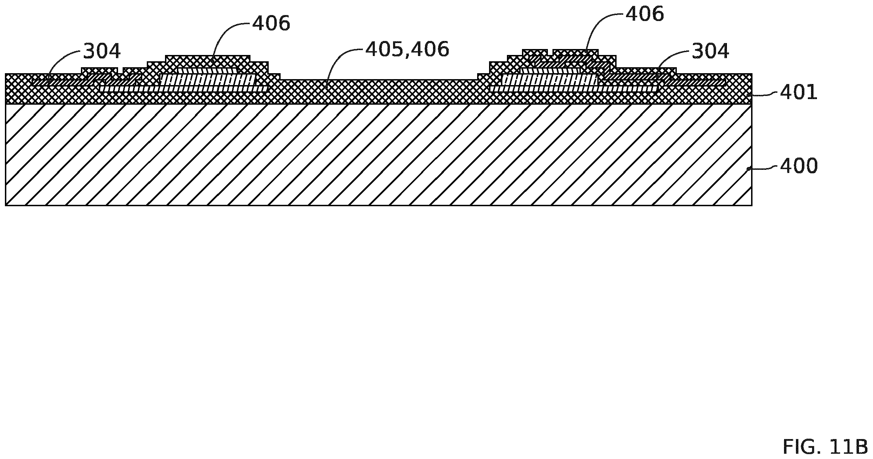

La troisième étape du procédé de fabrication du microsystème électromécanique 1 tel qu'illustré sur la figure 8B est illustrée sur la figure 11B. Elle comprend :
- le dépôt d'une couche de passivation 405, par exemple à base d'oxyde de silicium et/ou de nitrure de silicium, pouvant être déposée par PECVD,
- l'ouverture, à travers la couche de passivation 207, d'une zone de reprise de contact par électrode, cette ouverture étant réalisée par exemple par lithographie, et préférentiellement par gravure au plasma, ou par voie chimique humide,
- le dépôt d'une couche destinée à constituer une ligne électrique 304 par électrode, la couche étant par exemple à base d'or et pouvant être déposée par PVD,
- une gravure de la couche précédemment déposée de sorte à former une ligne électrique 304 par électrode, cette gravure étant réalisée par exemple par lithographie, et préférentiellement par gravure au plasma, ou par voie chimique humide, puis
- le dépôt d'une couche de passivation 406, par exemple à base d'oxyde de silicium et/ou de nitrure de silicium, pouvant être déposée par PECVD.

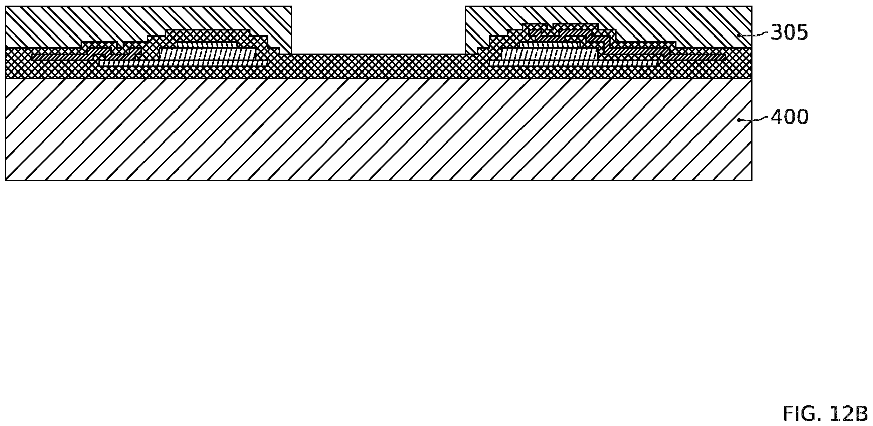

La quatrième étape du procédé de fabrication du microsystème électromécanique 1 tel qu'illustré sur la figure 8B est illustrée sur la figure 12B. Elle comprend le dépôt d'une couche destinée à constituer la poutre 305 du transducteur électromécanique 11, cette couche étant par exemple à base de silicium amorphe et pouvant être déposée par PVD. Elle peut comprendre ensuite une étape de planarisation de la couche précédemment déposée. Elle comprend ensuite une gravure de la couche précédemment déposée de sorte à former au moins une poutre 305 du transducteur électromécanique 11. Cette gravure étant réalisée par exemple par lithographie, et préférentiellement par gravure au plasma, ou par voie chimique humide.

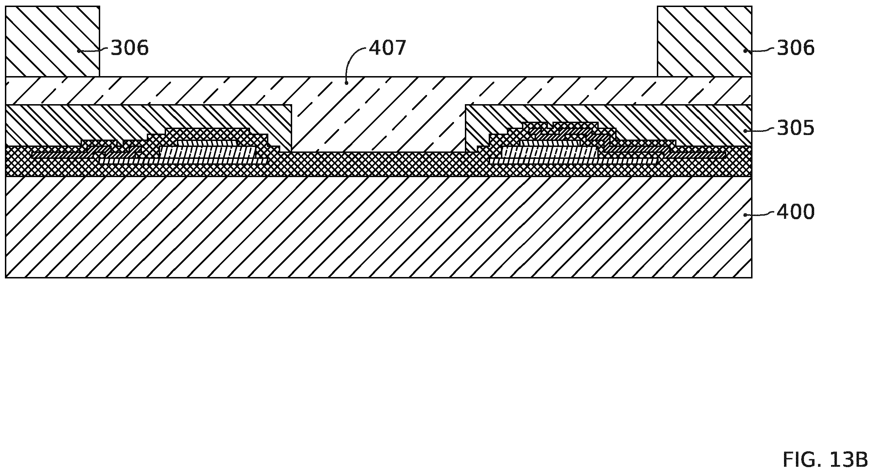

La cinquième étape du procédé de fabrication du microsystème électromécanique 1 tel qu'illustré sur la figure 8B est illustrée sur la figure 13B. Elle comprend :
- le dépôt d'une couche 407 à base d'un polymère et destinée à constituer la membrane déformable 12 ; Cette couche 407 est par exemple déposée par enduction centrifuge (ou spin coating en anglais). Le polymère à base duquel la couche 407 est constituée est par exemple à base de PDMS, et
- la formation d'au moins un espaceur 306 destiné à constituer au moins une partie de ladite au moins une paroi 133 latérale de la cavité 13.

La formation du ou des espaceurs 306 peut comprendre le laminage d'un matériau photosensible à base duquel le ou les espaceurs sont constitués, l'insolation, puis le développement du matériau photosensible. Ledit matériau photosensible peut être à base d'un polymère, et notamment à base de Siloxane. Le laminage du matériau photosensible peut comprendre le laminage d'un film sec dudit matériau.

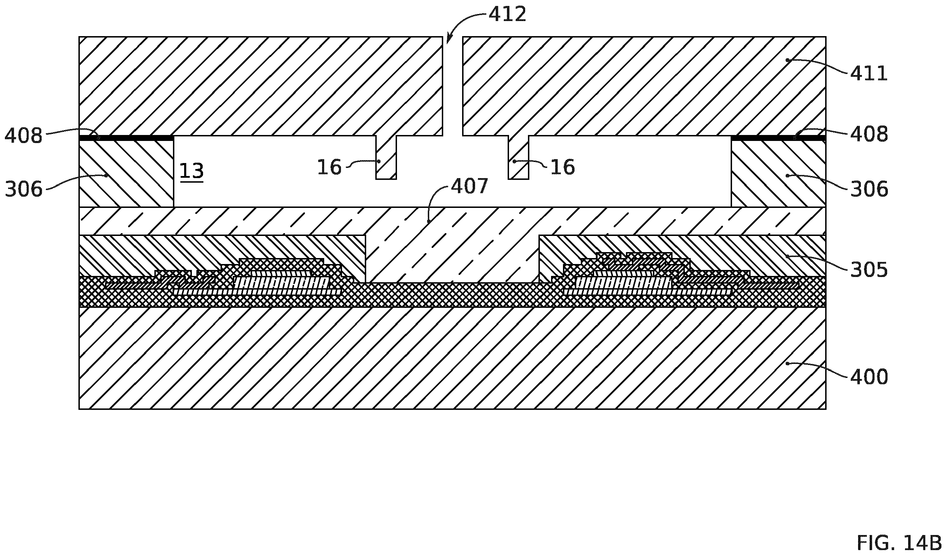

La sixième étape du procédé de fabrication du microsystème électromécanique 1 tel qu'illustré sur la figure 8B est illustrée sur la figure 14B. Elle comprend, le cas échéant, le dépôt de colle 408 au sommet de chaque espaceur 306. Selon un exemple optionnel, ce dépôt peut être réalisé par sérigraphie ou par dispense. Elle comprend le collage, sur le sommet du ou des espaceurs 306 (éventuellement par l'intermédiaire de la colle 408), d'un second substrat 411 pouvant être structuré de sorte à comprendre au moins l'un parmi un évent traversant 412 et une butée basse 16 telle que décrite ci-dessus. Dans un mode de réalisation alternatif, selon la nature de l'espaceur, celui-ci peut jouer le rôle de colle. À l'issue de cette sixième étape, la cavité 13 est formée qui est ouverte par au moins un évent traversant 412.

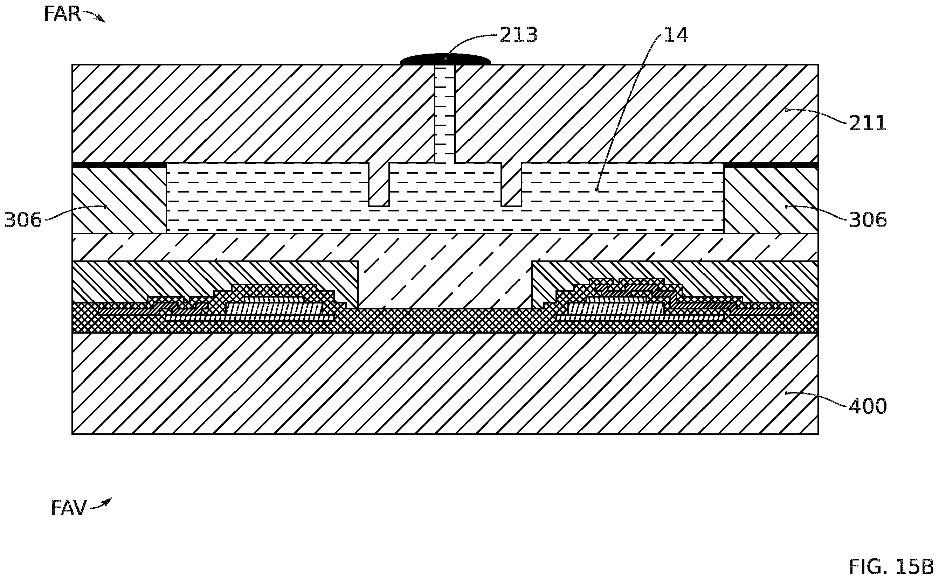

La septième étape du procédé de fabrication du microsystème électromécanique 1 tel qu'illustré sur la figure 8B est illustrée sur la figure 15B. Elle comprend le remplissage, de préférence sous vide, de la cavité 13 avec le milieu déformable 14 tel que décrit ci-dessus, par exemple par dispense à travers l'au moins un évent traversant 212. Elle comprend également la fermeture étanche de l'au moins un évent traversant 212, par exemple par dispense d'un matériau de scellement 213 au moins à l'embouchure de chaque évent traversant 212, le matériau de scellement 213 étant par exemple à base d'une colle époxy.

Une étape additionnelle permet d'obtenir le microsystème électromécanique 1 tel qu'illustré sur la figure 8B. Elle comprend la gravure du substrat 200. Cette gravure peut être réalisée par lithographie, et préférentiellement par gravure au plasma, ou par voie chimique humide. Elle comprend ensuite la gravure de la couche isolante 401 de sorte à exposer une partie de la membrane déformable 12 et à constituer tout ou partie du pion 122 et des éventuelles butées latérales 15.

Notons que, suite aux étapes décrites ci-dessus de fabrication du microsystème électromécanique 1 tel qu'illustré sur la figure 8B, le pion 122 prend la forme d'un empilement s'étendant directement depuis la membrane déformable 12 à l'opposé de la cavité 13 en présentant successivement le matériau de la couche isolante 401 et le matériau constituant le substrat 200. On constate que le pion 122 n'est pas centré sur la zone libre 121.

Notons également que, suite aux étapes décrites ci-dessus de fabrication du microsystème électromécanique 1 tel qu'illustré sur la figure 8B, les éventuelles butées latérales 15 prennent chacune la forme d'un empilement s'étendant, directement ou indirectement, depuis la poutre 305 à l'opposé de la cavité 13 en présentant successivement le matériau de la couche isolante 401 et le matériau constituant le substrat 200.

### Mode de réalisation illustré en figure 16

La figure 16 illustre, en coupe, un mode de réalisation correspondant aux modes de réalisation illustrés sur les figures 1 à 3A.

Ainsi, le transducteur électromécanique 11 n'entoure pas la zone libre 121 de la membrane 12. Ce mode de réalisation permet d'avoir plus de liberté pour adapter la dimension, la forme et le nombre des zones libres 121, sans que le transducteur électromécanique 11 n'impose de contrainte sur ces paramètres. Par exemple, pour une même dimension de transducteur électromécanique 11, ce mode de réalisation permet d'avoir une plus petite étendue de zone libre 121 et donc une déformation plus importante de cette dernière. L'inclinaison que l'on peut imposer au pion 122 est alors augmentée. Un autre intérêt est de permettre des mouvements selon l'axe deux sens opposés, i.e., vers le haut et vers le bas.

Sur cette figure, toutes les références numériques correspondent aux références numériques des figures 8A à 15B.

Sur la figure 16, on a représenté une entretoise 19. Elle peut prendre la forme d'un pilier ou d'un muret. Cette entretoise 19 permet de soutenir la membrane 12. Le milieu déformable 14 entoure cette entretoise 19. Cette entretoise 19 fait office de pilier à l'intérieur de la cavité 13. Le cas échéant, l'entretoise 19 permet, par exemple conjointement avec la portion du capot 18 qui la surplombe, de rigidifier un contour du transducteur électromécanique 11, de sorte que sa déformation soit le plus intégralement possible traduite en une déformation de la membrane 12. Plusieurs entretoises 19 peuvent être prévues.

Sur la figure 16, le transducteur électromécanique 11 est configuré de sorte à fléchir vers le bas lorsqu'il est sollicité, comme cela est le cas sur la figure 9A. En reprenant la structure du microsystème électromécanique illustré sur cette figure 16, on pourrait parfaitement modifier ce transducteur électromécanique 11 de sorte à ce qu'ils fléchissent vers le haut lorsqu'il est sollicité, comme cela est le cas sur la figure 9B.

Pour fabriquer le microsystème électromécanique 1 illustré en figure 16 ou bien sa variante avec flexion vers le bas du transducteur électromécanique 11, on pourra reprendre et adapter sans difficulté les étapes des procédés de réalisation décrits en détail en référence aux figures 9A à 15A et 9B à 15B.

### Autres modes de réalisation

En reprenant les principes, les caractéristiques et les effets techniques mentionnés en référence aux modes de réalisation décrits ci-dessus, de nombreuses variantes peuvent être envisagées. Quelques-unes de ses variantes sont brièvement exposées ci-dessous. Toutes les caractéristiques et tous les effets techniques mentionnés dans les exemples qui vont suivre et dans les exemples décrits ci-dessus sont combinables.

### - Disposition relative du transducteur électromécanique 11 et de la zone libre 121 de la membrane 12 :

La figure 17A illustre un mode de réalisation dans lequel le transducteur électromécanique entoure entièrement la zone libre 121 de la membrane 12. Tel est également le cas dans les modes de réalisation décrits sur les figures 8A à 15B.

Les figures 1 à 6E et 16 illustrent des modes de réalisation dans lesquels la zone libre 121 est distante du transducteur électromécanique 11. Tel est également le cas sur les figures 17B et 17C. Une portion fixe sépare la zone libre 121 et le transducteur électromécanique 11. Cette portion fixe peut être formée au moins en partie par le capot 18.

Sur la figure 17D, le transducteur électromécanique 11 est partiellement entouré par la zone libre 121 de la membrane 12. Une partie du transducteur électromécanique 11 est solidaire d'un boîtier du système électromécanique 1, par exemple de son capot 18. Une autre partie du transducteur électromécanique est entourée par la zone libre 121 de la membrane 12. Dans cet exemple, la zone libre 121 présente une forme générale en « U » autour du transducteur électromécanique 11. Sa portion centrale 125 présente alors également une forme générale en « U ». Le pourtour externe 129 et la portion périphérique 126 entourent la portion centrale 125. Des pions 122 positionnés de part et d'autre de la portion centrale 125 peuvent donc venir en contact les uns avec les autres lorsque la zone libre 121 se déforme. Les pions 122 définissent alors une ligne de préhension qui s'étend le long de la portion centrale 125. Dans cet exemple, cette de préhension forme également un « U ». Cela permet par exemple d'adapter la zone de préhension à des formes spécifiques d'objets que l'on souhaite saisir, capturer ou retenir.

### - Forme de la zone libre 121 et du transducteur électromécanique 11

Les formes de la zone libre 121 de la membrane 12 peuvent être adaptées avec une forte liberté en fonction des objectifs que l'on cherche à atteindre. Ces objectifs concernent par exemple l'amplitude de l'inclinaison des pions 122 ou la forme que l'on souhaite donner à une zone de préhension assurée par les pions 122.

Sur la figure 17A, la zone libre 121 présente une forme de disque. Sa portion centrale 125, sa portion périphérique 126 et son pourtour externe 129 présentent alors également une forme de disque ou de cercle.

Sur la figure 17B, la zone libre 121 présente une forme d'oblong ou d'ellipsoïde. Sa portion centrale 125, sa portion périphérique 126 et son pourtour externe 129 présentent alors également une forme d'oblong ou d'ellipsoïde.

Sur la figure 17C, la zone libre 121 présente une forme polygonale, ici un carré. Sa portion centrale 125, sa portion périphérique 126 et son pourtour externe 129 présentent alors également une polygonale.

Sur la figure 17D, la zone libre 121 forme un contour ouvert. Dans cet exemple non limitatif, ce contour ouvert forme un « U ».

De même que pour la forme de la zone libre 121, la forme du transducteur électromécanique 11 peut être adaptée comme on le souhaite.

### - Nombre et disposition relative des transducteurs électromécaniques

Sur les modes de réalisation illustrée sur les figures 1 à 16, un seul transducteur électromécanique été représenté, par souci de clarté.

Pour chacun de ces modes de réalisation, on peut néanmoins prévoir plusieurs transducteurs électromécaniques 11 pour un même système électromécanique 1.

Les figures 17B et 17C illustrent des modes de réalisation comprenant plusieurs transducteurs électromécaniques 11a, 11b.

Comme illustré sur cette figure 17B, les transducteurs électromécaniques 11a, 11b peuvent être séparés les uns des autres, par exemple par une portion de capot 18. Leurs parties mobiles ne sont alors pas en contact.

Comme illustré sur cette figure 17C, les transducteurs électromécaniques 11a, 11b peuvent être juxtaposés. Pour autant, ils ne sont pas entièrement jointifs. En effet, les matériaux piézoélectriques des deux transducteurs électromécaniques 11a, 11b doivent être séparés pour pouvoir être polarisés individuellement.

Selon un exemple, le matériau piézoélectrique d'un premier transducteur électromécanique 11b entoure, au moins partiellement, voire entièrement, le matériau piézoélectrique d'un ou plusieurs autres transducteurs électromécaniques 11a. Les parties mobiles de ces transducteurs électromécaniques 11a, 11b sont continues.

Naturellement, le nombre de transducteurs électromécaniques 11 peut être supérieur à deux.

Les transducteurs électromécaniques peuvent être sollicités simultanément ou successivement. L'amplitude de déplacement du pion 122 induite par chaque transducteur électromécanique 11 peut être identique ou différente.

La présence de plusieurs transducteurs électromécaniques 11 dans un même microsystème électromécanique 1 permet des modes de fonctionnement variés.

Selon un premier mode de réalisation, les transducteurs électromécaniques 11a, 11b sont configurés pour que, sous sollicitation, leurs parties mobiles induisent des déformations de la zone libre 121 entrainant une inclinaison du ou des pions 122 dans un même sens. L'inclinaison totale du ou des pions résulte alors du cumul du déplacement des parties mobiles de ces transducteurs électromécaniques 11a, 11b. Cela permet potentiellement de limiter la tension d'adressage.

Par ailleurs, lorsque les transducteurs électromécaniques 11 peuvent être activés indépendamment les uns des autres ou successivement, le microsystème électromécanique présente alors un fonctionnement pas à pas. Cela permet de contrôler avec une précision encore plus grande l'inclinaison du ou des pions.

Selon un deuxième mode de réalisation, éventuellement combinables avec le mode de réalisation pas à pas, au moins certains des transducteurs électromécaniques 11a, 11b sont configurés pour que, sous sollicitation, ils induisent une inclinaison du ou des pions 122 dans deux sens opposés. Ces deux transducteurs 11a, 11b électromécaniques sont donc antagonistes. Ainsi, au moins l'un de ces transducteurs électromécaniques permet d'incliner le pion 122 selon un premier sens et au moins un autre de ces transducteurs électromécaniques 11a, 11b permet d'incliner le pion 122 selon un deuxième sens opposé au premier sens. Cela permet d'augmenter encore l'amplitude de l'inclinaison possible pour le pion 122.

### - Nombre de zones libres 121

Comme illustré en figure 17C, on peut prévoir plusieurs zones libres 121a, 121b pour un même microsystème électromécanique 1. Cela peut par exemple permettre d'adapter la disposition des pions 122 aux objets que l'on souhaite déplacer, saisir ou capturer. Par ailleurs, la surface de chaque partie mobile ou des parties mobiles des transducteurs illustrés sur la figure 17C peut être au moins 5 fois, voire 10 fois, voire 20 fois supérieure à la surface des zones libres 121a, 121b de la membrane déformable 12.

### Système opto-électro-mécanique 3

Un autre aspect de l'invention concerne un système opto-électro-mécanique 3. Un exemple non limitatif d'un tel système est illustré sur la figure 18A. Le microsystème opto-électro-mécanique 3 illustré sur cette figure comprend au moins un microsystème électromécanique 1 tel que décrit ci-dessus et au moins un microsystème optique 31. Le microsystème électromécanique 1 est de préférence monté sur un support du microsystème opto-électro-mécanique 3.

Le microsystème optique 31 peut comprendre un micro-miroir à base de silicium. De préférence, le pion 122 n'est pas disposé au centre du miroir. Cela permet d'augmenter encore l'amplitude de l'inclinaison du miroir.

Le microsystème optique 31 peut être monté directement sur l'au moins un microsystème électromécanique 1 ou y être monté par l'intermédiaire d'un cadre. Il peut présenter des dimensions sensiblement égales à 2 mm x 5 mm et/ou, au maximum, une épaisseur d'environ 700 µm.

Lorsque le système opto-électro-mécanique 3 comprend au moins deux microsystèmes électromécaniques 1, chaque microsystème électromécanique 1 comprenant un unique pion 122, le microsystème optique 31 peut être fixé, directement ou indirectement, aux extrémités supérieures des pions. De la sorte, en entrainant tous les pions en un même déplacement, l'on déplace le microsystème optique 31 en un mouvement de translation circulaire.

On obtient ainsi un microsystème opto-électro-mécanique 3 bénéficiant d'une large capacité d'adaptation de son orientation optique.

Au vu de la description qui précède, il apparaît clairement que l'invention permet d'obtenir une inclinaison d'un ou de plusieurs pions 122 avec un débattement angulaire dont l'amplitude est importante et parfaitement maîtrisée. Cela permet d'obtenir des actionneurs, des dispositifs de préhension, voire des capteurs, à grand débattement et de grande précision.

L'invention n'est pas limitée aux modes de réalisation précédemment décrits et s'étend à tous les modes de réalisation couverts par les revendications.

Notamment, d'autres applications que celles décrites ci-dessus sont envisageables. Par exemple, le microsystème électromécanique 1 peut être agencé dans un système d'auto-assemblage de composants microélectroniques.

Par ailleurs, lorsque le microsystème électromécanique 1 assure une fonction de préhension, on peut prévoir qu'une extrémité libre 122b du pion 12 permette à elle seule de capturer un objet. Pour cela, on peut prévoir que cette extrémité libre 122b présente une forme ou un matériau adapté. Par exemple, l'extrémité libre 122b peut former un doigt recourbé ou crochet pour saisir un objet. Il peut également présenter toute autre forme complémentaire de l'objet pour saisir ce dernier. En outre, le matériau de l'extrémité libre 122b du pion 122 peut contribuer ou assurer à lui seul la capture d'un objet. On peut par exemple prévoir de revêtir une partie au moins du pion 122 d'un matériau adhésif ou tout au moins d'un matériau adhérent avec le matériau de l'objet à capturer. On peut également prévoir que le pion 122 comprenne un matériau magnétique ou ferromagnétique permettant de capturer par force magnétique un objet.

## Revendications

1. Microsystème électromécanique (1) comprenant :
• au moins un transducteur électromécanique (11) comprenant une partie mobile (111) entre une position d'équilibre, hors sollicitation, et une position hors équilibre, sous sollicitation,
• au moins une membrane déformable (12),
• une cavité (13) déformable, délimitée par des parois (131, 132, 133), au moins une partie de la membrane déformable (12) formant au moins une partie d'une première paroi (131) prises parmi lesdites parois (131, 132, 133) de la cavité (13), la cavité (13) étant configurée pour contenir hermétiquement un milieu déformable (14) propre à conserver un volume sensiblement constant sous l'action d'un changement de pression externe exercée sur le milieu déformable (14) à travers l'une paroi des parois (131, 132, 133) de la cavité (13),
dans lequel la partie mobile (111) du transducteur électromécanique (11) est configurée de sorte que son mouvement soit fonction dudit changement de pression externe, ou inversement que son mouvement induise un changement de pression externe, et dans lequel ladite au moins une partie de la membrane déformable (12) présente au moins une zone libre (121) de se déformer, de préférence de façon élastique, en fonction dudit changement de pression externe, la zone libre (121) présentant un pourtour externe (129) et une portion périphérique (126) qui s'étend depuis le pourtour externe (129) et jusqu'à une portion centrale (125) de la zone libre (121), **caractérisé en ce que** le microsystème électromécanique (1) comprend au moins un pion (122), configuré pour prendre appui sur la portion périphérique (126) de la zone libre (121) de sorte qu'une déformation de la zone libre (121) de la membrane (12) entraine une inclinaison du pion (122).

2. Microsystème électromécanique (1) selon la revendication précédente dans lequel en l'absence de déformation, la zone libre (121) de la membrane (12) s'étend principalement dans un plan (xy), dit plan hors déformation, et la perpendiculaire à la tangente en un point donné de la zone libre (121) s'étend selon une direction T1 perpendiculaire au plan hors déformation, et lorsque la membrane (12) se déforme, la perpendiculaire à la tangente en un point donné de la portion périphérique (126) de la zone libre (121) s'étend selon une direction Ti inclinée d'un angle αi par rapport à la direction T1, l'angle αi augmentant au fur à mesure que l'on s'éloigne de la portion centrale (125) et que l'on se rapproche du pourtour externe (129) de la zone libre (121).

3. Microsystème électromécanique (1) selon la revendication précédente dans lequel le pion (122) s'étend principalement selon une direction longitudinale (122c) et dans lequel lorsque la membrane (12) n'est pas déformée, la direction longitudinale (122c) du pion (122) est sensiblement perpendiculaire à un plan (xy) dans lequel s'étend principalement une face externe (12e) de la membrane (12) lorsque la membrane (12) n'est pas déformée, le microsystème électromécanique étant configuré de sorte qu'une déformation de la zone libre (121) de la membrane (12) entraine une inclinaison de la première extrémité (122a) en direction de la portion centrale (124) de la zone libre (121).

4. Microsystème électromécanique (1) selon l'une quelconque des revendications précédentes, dans lequel la portion centrale (125) comprend un centre (124) qui correspond au barycentre de la zone libre (121).

5. Microsystème électromécanique (1) selon l'une quelconque des revendications précédentes, dans lequel la zone libre (121) est délimitée par un pourtour externe (129), le pion (122) étant situé à une distance minimale D122 du pourtour externe (129), telle que D122 est inférieure à k fois une distance D124,
• D122 étant mesurée entre et le pion (122) et le point (128) du pourtour externe (129) le plus proche du pion (122), et
• la distance D124 étant mesurée entre ce même point (128) et le centre (124) de la zone libre (121),
• k étant inférieur à 0,7, de préférence k étant inférieur à 0,5, de préférence k étant inférieur à 0,3.

6. Microsystème électromécanique (1) selon l'une quelconque des revendications précédentes, comprenant une pluralité de pions (122), prenant chacun appui sur la portion périphérique (126) de la zone libre (121) de sorte qu'une déformation de la zone libre (121) de la membrane (12) entraine une inclinaison des pions (122).

7. Microsystème électromécanique (1) selon la revendication précédente, dans lequel les pions (122) présentent une extrémité libre (122b), opposée à l'extrémité (122a) par laquelle ils prennent appui sur la portion périphérique (126) de la zone libre (121), les pions (122) étant conformés de sorte qu'une déformation de la zone libre (121) de la membrane (12) entraine sélectivement un rapprochement ou un éloignement des extrémités libres (122b) des pions (122).

8. Microsystème électromécanique (1) selon l'une quelconque des deux revendications précédentes, dans lequel les pions (122) sont conformés de sorte qu'une déformation de la zone libre (121) de la membrane (12) entraine sélectivement une mise en contact ou un éloignement des extrémités libres (122b) des pions (122).

9. Microsystème électromécanique (1) selon l'une quelconque des trois revendications précédentes, dans lequel les pions (122) sont répartis sur la portion périphérique (126) de sorte que le rapprochement de leurs extrémités libres (122b) permette de former une cage au-dessus de la zone libre (121).

10. Microsystème électromécanique (1) selon l'une quelconque des revendications précédentes, dans lequel le ou les pions (122) sont configurés pour coopérer avec un objet formant un organe externe (2) de sorte que le mouvement de la partie mobile (111) du transducteur électromécanique (11) soit fonction d'un déplacement du ou des pions (122) entrainés par l'organe externe (2) ou inversement que le mouvement de la partie mobile (111) du transducteur électromécanique (11) induise un déplacement, en particulier une inclinaison, de l'organe externe (2) par l'intermédiaire du ou des pions (122).

11. Microsystème électromécanique (1) selon l'une quelconque des revendications précédentes dans lequel le ou les pions (122) sont fixés sur ladite zone libre (121), de préférence au contact directe de ladite zone libre (121).

12. Microsystème électromécanique (1) selon l'une quelconque des revendications précédentes comprenant une pluralité de transducteurs électromécaniques (11) et dans lequel au moins certains des transducteurs électromécaniques (11) de ladite pluralité sont configurés pour que, sous sollicitation, leurs parties mobiles (111), induisent des déformations de la zone libre (121) de la membrane (12) entrainant une inclinaison de l'au moins un pion (122) dans un même sens.

13. Microsystème électromécanique (1) selon l'une quelconque des revendications précédentes comprenant une pluralité de transducteurs électromécaniques (11) et dans lequel au moins certains des transducteurs électromécaniques (11) de ladite pluralité sont configurés pour que, sous sollicitation, leurs parties mobiles (111), induisent des déformations de la zone libre (121) de la membrane (12) entrainant une inclinaison de l'au moins un pion (122) dans deux sens opposés.

14. Microsystème électromécanique (1) selon l'une quelconque des revendications précédentes, dans lequel la membrane déformable (12) est configurée de sorte que sa zone libre (121) est capable de se déformer avec une amplitude d'au moins 50 µm, voire d'environ 100 µm.

15. Système opto-électro-mécanique (3) comprenant au moins un microsystème électromécanique (1) selon l'une quelconque des revendications précédentes et au moins un microsystème optique (31), le microsystème optique (31) comprenant au moins un miroir, de préférence à base de silicium, le système opto-électro-mécanique (3) étant configuré de sorte à ce que le mouvement de la partie mobile (111) du transducteur électromécanique provoque un déplacement de l'au moins un miroir.

## Patentansprüche

1. Elektromechanisches Mikrosystem (1), umfassend:
• mindestens einen elektromechanischen Wandler (11), der einen beweglichen Teil (111) zwischen einer belastungsfreien Gleichgewichtslage und einer Ungleichgewichtslage unter Belastung umfasst,
• mindestens eine verformbare Membran (12),
• einen verformbaren Hohlraum (13), der von Wänden (131, 132, 133) begrenzt wird, wobei mindestens ein Teil der verformbaren Membran (12) mindestens einen Teil einer ersten Wand (131), die aus den Wänden (131, 132, 133) des Hohlraums (13) ausgewählt ist, bildet, wobei der Hohlraum (13) so konfiguriert ist, dass er hermetisch dicht ein verformbares Medium (14) enthält, das geeignet ist, unter der Wirkung einer Änderung des Außendrucks, der durch die eine Wand der Wände (131, 132, 133) des Hohlraums (13) hindurch auf das verformbare Medium (14) ausgeübt wird, ein im Wesentlichen konstantes Volumen zu bewahren,
wobei der bewegliche Teil (111) des elektromechanischen Wandlers (11) so konfiguriert ist, dass seine Bewegung von der Änderung des Außendrucks abhängig ist, oder umgekehrt, dass seine Bewegung eine Änderung des Außendrucks induziert, und wobei der mindestens eine Teil der verformbaren Membran (12) mindestens einen freien Bereich (121) aufweist, um sich, vorzugsweise elastisch, in Abhängigkeit von der Änderung des Außendrucks zu verformen, wobei der freie Bereich (121) einen Außenumfang (129) und einen peripheren Abschnitt (126) aufweist, der sich vom Außenumfang (129) und bis zu einem mittleren Abschnitt (125) des freien Bereichs (121) erstreckt, **dadurch gekennzeichnet, dass** das elektromechanische Mikrosystem (1) mindestens einen Stift (122) umfasst, der so konfiguriert ist, dass er auf dem peripheren Abschnitt (126) des freien Bereichs (121) aufliegt, sodass eine Verformung des freien Bereichs (121) der Membran (12) eine Neigung des Stifts (122) bewirkt.

2. Elektromechanisches Mikrosystem (1) nach dem vorstehenden Anspruch, wobei sich bei fehlender Verformung der freie Bereich (121) der Membran (12) hauptsächlich in einer als verformungsfreie Ebene bezeichneten Ebene (xy) erstreckt, und sich die Senkrechte zur Tangente an einem gegebenen Punkt des freien Bereichs (121) entlang einer Richtung T1 senkrecht zur verformungsfreien Ebene erstreckt, und wenn sich die Membran (12) verformt, die Senkrechte zur Tangente an einem gegebenen Punkt des peripheren Abschnitts (126) des freien Bereichs (121) sich entlang einer Richtung Ti erstreckt, die um einen Winkel αi in Bezug auf die Richtung T1 geneigt ist, wobei der Winkel αi, je weiter man sich vom mittleren Abschnitt (125) entfernt und sich dem Außenumfang (129) des freien Bereichs (121) annähert, größer wird.

3. Elektromechanisches Mikrosystem (1) nach dem vorstehenden Anspruch, wobei sich der Stift (122) hauptsächlich entlang einer Längsrichtung (122c) erstreckt und wobei, wenn die Membran (12) nicht verformt ist, die Längsrichtung (122c) des Stifts (122) im Wesentlichen senkrecht zu einer Ebene (xy) ist, in der sich hauptsächlich eine Außenseite (12e) der Membran (12) erstreckt, wenn die Membran (12) nicht verformt ist, wobei das elektromechanische Mikrosystem so konfiguriert ist, dass eine Verformung des freien Bereichs (121) der Membran (12) eine Neigung des ersten Endes (122a) in Richtung des mittleren Abschnitts (124) des freien Bereichs (121) bewirkt.

4. Elektromechanisches Mikrosystem (1) nach einem der vorstehenden Ansprüche, wobei der mittlere Abschnitt (125) einen Mittelpunkt (124) umfasst, der dem Schwerpunkt des freien Bereichs (121) entspricht.

5. Elektromechanisches Mikrosystem (1) nach einem der vorstehenden Ansprüche, wobei der freie Bereich (121) von einem Außenumfang (129) begrenzt wird, wobei sich der Stift (122) in einem minimalen Abstand D122 vom Außenumfang (129) befindet, sodass D122 kleiner ist als das k-fache eines Abstands D124,
• wobei D122 zwischen dem Stift (122) und dem dem Stift (122) am nächsten liegenden Punkt (128) des Außenumfangs (129) gemessen wird, und
• wobei der Abstand D124 zwischen demselben Punkt (128) und dem Mittelpunkt (124) des freien Bereichs (121) gemessen wird,
• wobei k kleiner als 0,7 ist, wobei vorzugsweise k kleiner als 0,5 ist, wobei vorzugsweise k kleiner als 0,3 ist.

6. Elektromechanisches Mikrosystem (1) nach einem der vorstehenden Ansprüche, das eine Vielzahl von Stiften (122) umfasst, die jeweils auf dem peripheren Abschnitt (126) des freien Bereichs (121) aufliegen, sodass eine Verformung des freien Bereichs (121) der Membran (12) eine Neigung der Stifte (122) bewirkt.

7. Elektromechanisches Mikrosystem (1) nach dem vorstehenden Anspruch, wobei die Stifte (122) ein freies Ende (122b) aufweisen, das dem Ende (122a), mit dem sie auf dem peripheren Abschnitt (126) des freien Bereichs (121) aufliegen, gegenüberliegt, wobei die Stifte (122) so ausgebildet sind, dass eine Verformung des freien Bereichs (121) der Membran (12) selektiv eine Annäherung oder eine Entfernung der freien Enden (122b) der Stifte (122) bewirkt.

8. Elektromechanisches Mikrosystem (1) nach einem der zwei vorstehenden Ansprüche, wobei die Stifte (122) so ausgebildet sind, dass eine Verformung des freien Bereichs (121) der Membran (12) selektiv ein Inkontaktbringen oder eine Entfernung der freien Enden (122b) der Stifte (122) bewirkt.

9. Elektromechanisches Mikrosystem (1) nach einem der drei vorstehenden Ansprüche, wobei die Stifte (122) auf dem peripheren Abschnitt (126) verteilt sind, sodass die Annäherung ihrer freien Enden (122b) es ermöglicht, einen Käfig über dem freien Bereich (121) zu bilden.

10. Elektromechanisches Mikrosystem (1) nach einem der vorstehenden Ansprüche, wobei der oder die Stifte (122) so konfiguriert sind, dass sie mit einem Objekt zusammenwirken, das ein äußeres Organ (2) bildet, sodass die Bewegung des beweglichen Teils (111) des elektromechanischen Wandlers (11) von einer Verlagerung des oder der Stifte (122), die von dem äußeren Organ (2) bewirkt wird, abhängt oder umgekehrt, dass die Bewegung des beweglichen Teils (111) des elektromechanischen Wandlers (11) eine Verlagerung, insbesondere eine Neigung, des äußeren Organs (2) mittels des oder der Stifte (122) induziert.

11. Elektromechanisches Mikrosystem (1) nach einem der vorstehenden Ansprüche, wobei der oder die Stifte (122) auf dem freien Bereich (121), vorzugsweise in direktem Kontakt mit dem freien Bereich (121), befestigt sind.

12. Elektromechanisches Mikrosystem (1) nach einem der vorstehenden Ansprüche, das eine Vielzahl von elektromechanischen Wandlern (11) umfasst, und wobei mindestens einige der elektromechanischen Wandler (11) der Vielzahl so konfiguriert sind, dass ihre beweglichen Teile (111) unter Belastung Verformungen des freien Bereichs (121) der Membran (12) induzieren, die eine Neigung des mindestens einen Stifts (122) in dieselbe Richtung bewirken.

13. Elektromechanisches Mikrosystem (1) nach einem der vorstehenden Ansprüche, das eine Vielzahl von elektromechanischen Wandlern (11) umfasst, und wobei mindestens einige der elektromechanischen Wandler (11) der Vielzahl so konfiguriert sind, dass ihre beweglichen Teile (111) unter Belastung Verformungen des freien Bereichs (121) der Membran (12) induzieren, die eine Neigung des mindestens einen Stifts (122) in zwei entgegengesetzte Richtungen bewirken.

14. Elektromechanisches Mikrosystem (1) nach einem der vorstehenden Ansprüche, wobei die verformbare Membran (12) so konfiguriert ist, dass ihr freier Bereich (121) in der Lage ist, sich mit einer Amplitude von mindestens 50 µm, ja sogar von etwa 100 µm, zu verformen.

15. Opto-elektro-mechanisches System (3), das mindestens ein elektromechanisches Mikrosystem (1) nach einem der vorstehenden Ansprüche und mindestens ein optisches Mikrosystem (31) umfasst, wobei das optische Mikrosystem (31) mindestens einen Spiegel, vorzugsweise auf Siliziumbasis, umfasst, wobei das opto-elektro-mechanische System (3) so konfiguriert ist, dass die Bewegung des beweglichen Teils (111) des elektromechanischen Wandlers eine Verlagerung des mindestens einen Spiegels hervorruft.

## Claims

1. An electromechanical microsystem (1) comprising:
• at least one electromechanical transducer (11) comprising a movable portion (111) between a balance position, off-load, and an out-of-balance position, under load,
• at least one deformable membrane (12),
• a deformable cavity (13), delimited by walls (131, 132, 133), at least one portion of the deformable membrane (12) forming at least one portion of a first wall (131) selected amongst said walls (131, 132, 133) of the cavity (13), the cavity (13) being configured to hermetically contain a deformable medium (14) capable of keeping a substantially constant volume under the action of a change of an external pressure exerted on the deformable medium (14) through one of the walls (131, 132, 133) of the cavity (13),
wherein the movable portion (111) of the electromechanical transducer (11) is configured so that its movement depends on said change in the external pressure, or conversely its movement induces a change in the external pressure, and wherein said at least one portion of the deformable membrane (12) has at least one free area (121) that is deformable, preferably elastically, according to said change in the external pressure, the free area (121) having an outer perimeter (129) and a peripheral portion (126) which extends from the outer perimeter (129) and up to a central portion (125) of the free area (121), **characterised in that** the electromechanical microsystem (1) comprises at least one pin (122), configured to bear on the peripheral portion (126) of the free area (121) so that a deformation of the free area (121) of the membrane (12) causes an inclination of the pin (122).

2. Electromechanical microsystem (1) according to the previous claim, wherein in the absence of deformation, the free area (121) of the membrane (12) extends primarily in a plane (xy), called off-deformation plane, and the perpendicular to the tangent at a given point of the free area (121) extends according to a direction T1 perpendicular to the off-deformation plane, and when the membrane (12) is deformed, the perpendicular to the tangent at a given point of the peripheral portion (126) of the free area (121) extends according to a direction Ti inclined by an angle αi with respect to the direction T1, the angle αi increasing progressively as it moves away from the central portion (125) and approaches the outer perimeter (129) of the free area (121).

3. Electromechanical microsystem (1) according to the previous claim, wherein the pin (122) extends primarily according to a longitudinal direction (122c) and wherein when the membrane (12) is not deformed, the longitudinal direction (122c) of the pin (122) is substantially perpendicular to a plane (xy) wherein an outer face (12e) of the membrane (12) primarily extends when the membrane (12) is not deformed, the electromechanical microsystem being configured so that a deformation of the free area (121) of the membrane (12) causes an inclination of the first end (122a) in the direction of the central portion (124) of the free area (121).

4. Electromechanical microsystem (1) according to any one of the previous claims, wherein the central portion (125) comprises a centre (124) which corresponds to the barycentre of the free area (121).

5. Electromechanical microsystem (1) according to any one of the previous claims, wherein the free area (121) is delimited by an outer perimeter (129), the pin (122) being located at a minimum distance D122 from the outer perimeter (129), such that D122 is smaller than k times a distance D124,
• D122 being measured between the pin (122) and the point (128) of the outer perimeter (129) the closest to the pin (122), and
• the distance D124 being measured between that same point (128) and the centre (124) of the free area (121),
• k being less than 0.7, preferably k being less than 0.5, preferably k being less than 0.3.

6. Electromechanical microsystem (1) according to any one of the previous claims, comprising a plurality of pins (122), each bearing on the peripheral portion (126) of the free area (121) so that a deformation of the free area (121) of the membrane (12) causes an inclination of the pins (122).

7. Electromechanical microsystem (1) according to the previous claim, wherein the pins (122) have a free end (122b), opposite to the end (122a) by which they bear on the peripheral portion (126) of the free area (121), the pins (122) being shaped so that a deformation of the free area (121) of the membrane (12) selectively causes an approach or a separation of the free ends (122b) of the pins (122).

8. Electromechanical microsystem (1) according to any one of the previous claims, wherein the pins (122) are shaped so that a deformation of the free area (121) of the membrane (12) selectively causes a contact or a separation of the free ends (122b) of the pins (122).

9. Electromechanical microsystem (1) according to any one of the three previous claims, wherein the pins (122) are distributed over the peripheral portion (126) so that the approach of their free ends (122b) allows the forming of a cage above the free area (121).

10. Electromechanical microsystem (1) according to any one of the previous claims, wherein the pin(s) (122) are configured so as to cooperate with an object forming an external member (2) so that the movement of the movable portion (111) of the electromechanical transducer (11) depends on a displacement of the pin(s) (122) driven by the external member (2) or conversely so that the movement of the movable portion (111) of the electromechanical transducer (11) induces a displacement, in particular an inclination, of the external member (2) through the pin(s) (122).

11. Electromechanical microsystem (1) according to any one of the previous claims, wherein the pin(s) (122) are fixed to said free area (121), preferably by direct contact with said free area (121).

12. Electromechanical microsystem (1) according to any one of the previous claims, comprising a plurality of electromechanical traducers (11) and wherein at least some of the electromechanical transducers (11) of said plurality are configured so that, under load, their movable portions (111) induce deformations of the free area (121) of the membrane (12) causing an inclination of the at least one pin (122) in the same direction.

13. Electromechanical microsystem (1) according to any one of the previous claims, comprising a plurality of electromechanical traducers (11) and wherein at least some of the electromechanical transducers (11) of said plurality are configured so that, under load, their movable portions (111) induce deformations of the free area (121) of the membrane (12) causing an inclination of the at least one pin (122) in two opposite directions.

14. Electromechanical microsystem (1) according to any one of the previous claims, wherein the deformable membrane (12) is configured so that its free area (121) is capable of deforming with an amplitude of at least 50 µm, and possibly around 100 µm.

15. An opto-electro-mechanical system (3) comprising at least one electromechanical microsystem (1) according to any one of the previous claims and at least one optical microsystem (31), the optical microsystem (31) comprising at least one mirror, preferably based on silicon, the opto-electro-mechanical system (3) being configured so that the movement of the movable portion (111) of the electromechanical transducer (11) causes a displacement of the at least one mirror.
